# EUROPEAN PATENT APPLICATION

(11) **EP 1 507 294 A2**
(43) Date of publication of application: **16.02.2005**
(21) Application number: 04254361.1
(22) Date of filing: 21.07.2004
(51) Int. Cl.: H01L 29/786, H01L 21/336

(54) **Semiconductor device with surrounding gate**

(30) Priority: 12.08.2003 JP 2003207340
(71) Applicant: Masuoka, Fujio, Sendai-shi, Miyagi 981-0923 (JP); Sharp Kabushiki Kaisha, Osaka-shi, Osaka 545-8522 (JP)
(72) Inventor: Masuoka, Fujio, Sendai-shi Miyagi 981-0923 (JP); Horii, Shinji, Okayama 714-0086 (JP); Tanigami, Takuji, Fukuyama-shi Hiroshima 720-0082 (JP); Yokoyama, Takashi, Kasaoka-shi Okayama 714-0086 (JP); Takeuchi, Noboru, Hiroshima 721-0942 (JP)
(74) Representative: Brown, Kenneth Richard

(57) **Abstract**

A semiconductor device comprising a memory cell which includes: a pillar-shaped semiconductor layer of a first conductive type formed on a semiconductor substrate; source and drain diffusion layers of a second conductive type formed in upper and lower portions of the pillar-shaped semiconductor layer; a semiconductor layer of the second conductive type or a cavity formed inside the pillar-shaped semiconductor layer; and a gate electrode formed on a side face of the pillar-shaped semiconductor layer via a gate insulating film, or a control gate electrode formed on the side face of the pillar-shaped semiconductor layer via a charge accumulation layer.

## Description

### BACKGROUND OF THE INVENTION

### Field of the Invention

The present invention relates to a semiconductor device. More specifically, the present invention relates to a semiconductor device that can be appropriately utilized in a semiconductor integrated circuit using MOS transistors and memory transistors.

### Description of the Related Art

The degree of integration of semiconductor integrated circuits keeps steadily increasing. Together with this increase in the integration, the miniaturization of manufactured semiconductor integrated circuits has advanced in a submicron region. However, a variety of problems arise in a semiconductor integrated circuit of which the level of miniaturization has advanced in a submicron region in the case where the semiconductor integrated circuit has a conventional planer-type structure (for example, a conventional planer-type MOS (Metal-Oxide-Semiconductor) transistor).

The first problem, for example, is the degradation of the transistor characteristics which occurs due to lowering of the threshold voltage caused by a so-called short channel effect or due to a hot carrier effect when the gate length of the MOS transistor becomes short. The second problem is an increase in the threshold voltage due to a so-called narrow channel effect, and a failure in securing the required amount of current due to the narrow channel width which occur when the gate width of the MOS transistor becomes narrow.

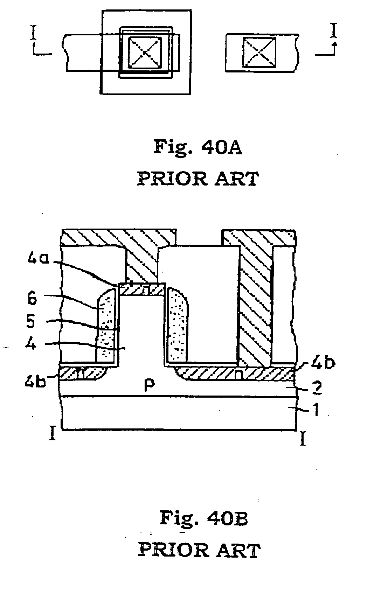

In order to solve the two problems with the conventional planer-type MOS transistor as described above, a MOS transistor having a three-dimensional structure as shown in Figs. 40A and 40B, which is referred to as an SGT (Surrounding Gate Transistor) has been proposed in Japanese Unexamined Patent Publication No. HEI 6 (1994)-334146. Figs. 40A and 40B show an n-channel SGT. In the SGT of Figs. 40A and 40B, a gate electrode 6 is formed on the sides of a p-type pillar-shaped semiconductor layer (for example, a pillar-shaped silicon layer) 4 via a gate insulating film 5 in a manner where the gate electrode 6 surrounds the pillar that has been formed on a substrate 1 such as a silicon substrate having a p-type layer as a surface layer. Source and drain diffusion layers (4a, 4b) are respectively formed in the upper and lower portions of the pillar-shaped semiconductor layer 4. In the case of a p-channel SGT, the conductivities of the channel region, the source and drain diffusion layers and the gate electrode become opposite of those in the n-channel SGT while the structures are approximately the same.

Accordingly, in this structure, the pillar-shaped semiconductor layer 4 can be made taller so that the gate length can be elongated without increasing the area occupied by the MOS transistor; consequently, the first problem can be solved. In addition, the region surrounding the pillar-shaped semiconductor layer 4 is used as the channel region in a manner where a large gate width can be secured within a small occupied region; consequently, the second problem can also be solved.

Furthermore, the gate electrode has an enhanced ability to control the channel region due to the structure where the gate electrode surrounds the channel region in the SGT. As a result, the sub-threshold characteristics of the MOS transistor are steep; therefore, there is an advantage in that a transistor having a small sub-threshold swing (which is referred to as S factor and is represented by S = (In 10) • dVgs/d(logId) = (In10) • (kT/q) (1 + Cd/Cox)) can be implemented. Here, Vgs is a potential between a gate and a source of a transistor, Id is a drain current, Cd is a capacitance of a depletion layer and Cox is a gate capacitance.

Furthermore, the depletion layer that extends from the surface of the channel region of the sidewalls of the pillar-shaped semiconductor layer 4 depletes the entirety of the pillar-shaped semiconductor layer 4; thereby, an ideal sub-threshold swing can be obtained in the case where the capacitance of the depletion layer (the above-described Cd) does not exist.

In addition, in the case where the width of the pillar-shaped semiconductor layer 4 is made narrower, a depletion layer extends from the source or drain diffusion layer that has been formed in the lower portion of the pillar-shaped semiconductor layer 4, so that the entirety of the pillar-shaped semiconductor layer 4 can be depleted by this depletion layer. As a result, the channel region is disconnected from the substrate 1; thereby, a fluctuation in the threshold voltage does not occur easily in accordance with a fluctuation in the substrate bias. Accordingly, a MOS transistor of which the substrate bias effect has been reduced can be obtained.

In addition, the inside of the pillar-shaped semiconductor layer 4 is completely depleted; thereby, the leak current between the source and drain layers can be reduced at the time when the transistor has been turned off. Thus, the electrical power consumption can be reduced.

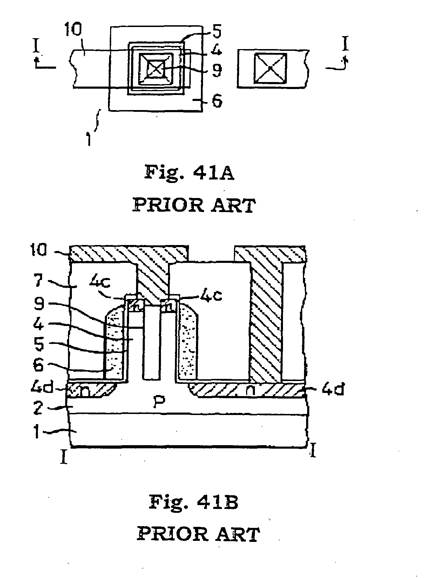

Furthermore, in the SGT described in Japanese Unexamined Patent Publication No. HEI 6 (1994)-334146, an insulating region 9 is provided inside the above-described pillar-shaped semiconductor layer so as to extend in the direction of the pillar height; thus, the structure as shown in Figs. 41A and 41B has also been proposed. In the figures, an interlayer insulating film is denoted as 7. According to this structure, it becomes possible to obtain a MOS transistor having an ideal sub-threshold swing or not having a substrate bias effect even if the width of the above-described pillar-shaped semiconductor layer has not been miniaturized to a level of a sub-quarter micron.

That is to say, the insulating layer 9 is formed inside the channel region of the pillar-shaped semiconductor layer in the configuration of Figs. 41A and 41B. As a result, the entirety of the channel region of the pillar-shaped semiconductor layer can be completely depleted by the depletion layer extending from the source or drain layer in the upper or lower portion regardless of the width of the pillar-shaped semiconductor layer. Therefore, a MOS transistor having an ideal sub-threshold swing or not having a substrate bias effect can be obtained.

As described above, the SGT has a potential to become a completely depleted MOS transistor having a small sub-threshold swing wherein the substrate bias effect has been reduced, and the problems of degradation of the transistor characteristics caused in a planer-type MOS transistor that has been miniaturized by a so-called short channel effect and narrow channel effect can be solved.

In order to implement such an idealistic SGT, it is necessary for the depletion layer extending from the source or drain diffusion layer formed in the lower portion of the pillar-shaped semiconductor layer to deplete the entirety of the pillar-shaped semiconductor layer. Therefore, the width of the pillar-shaped semiconductor layer must be reduced to a level of, for example, a sub-quarter micron.

However, the formation of an SGT having such a structure is difficult from a point of view of the lithographic technology. Furthermore, when the width of the pillar-shaped semiconductor layer is reduced, the channel region is also reduced, limiting the freedom in the width of the pillar-shaped semiconductor layer, and a problem arises wherein it becomes disadvantageous to design an LSI.

In addition, an insulating region is formed inside the channel region of the pillar-shaped semiconductor layer; thereby, the entirety of the channel region in the pillar-shaped semiconductor layer can completely be depleted by using the depletion layer extending from the source or drain diffusion layer in the upper or lower portion regardless of the width of the pillar-shaped semiconductor layer. In this case, however, it is necessary for the distance between the insulating region formed inside the channel region in the above-described pillar-shaped semiconductor layer and the lower surface of the channel region to be equal to or smaller than the width of the depletion layer of the channel region in order to implement a completely depleting operation.

In addition, a so-called S-SGT (Stacked-Surrounding Gate Transistor) wherein multiple steps of SGTs are stacked in the direction of the height of the pillar-shaped semiconductor layer is described in the above publication. However, it is difficult to deplete the channel region of the pillar-shaped semiconductor layer in this S-SGT.

### SUMMARY OF THE INVENTION

The present invention is made in view of the above-described problems, and one of objects of the invention is to reduce the substrate bias effect of MOS transistors or memory cells having a three-dimensional structure represented by an SGT or of memory cells having a multiple step stacked-type three-dimensional structure represented by an S-SGT flash memory.

Thus, the present invention provides a semiconductor device comprising a memory cell which includes:
a pillar-shaped semiconductor layer of a first conductive type formed on a semiconductor substrate;
source and drain diffusion layers of a second conductive type formed in upper and lower portions of the pillar-shaped semiconductor layer;
a semiconductor layer of the second conductive type or a cavity formed inside the pillar-shaped semiconductor layer; and
a gate electrode formed on a side face of the pillar-shaped semiconductor layer via a gate insulating film, or a control gate electrode formed on the side face of the pillar-shaped semiconductor layer via a charge accumulation layer.

The present invention also provides a semiconductor device comprising two or more stacked memory cells each of which includes:
a pillar-shaped semiconductor layer formed on a semiconductor substrate;
source and drain diffusion layers of a second conductive type formed in upper and lower portions of the pillar-shaped semiconductor layer;
an insulator formed inside the pillar-shaped semiconductor layer; and
a control gate electrode formed on a side face of the pillar-shaped semiconductor layer via a charge accumulation layer,
wherein the pillar-shaped semiconductor layers forming the respective memory cells have a step-like structure in that the pillar-shaped semiconductor layers are stacked so that the cross-sectional areas in the horizontal direction relative to the surface of the semiconductor substrate become smaller, step by step, and
the charge accumulation layer or the control gate electrode is placed over a step portion of the stacked body of the pillar-shaped semiconductor layers having a step-like structure and over a side face of the pillar-shaped semiconductor layer directly above the step portion.

These and other objects of the present application will become more readily apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS

Figs. 1 to 9 are schematic cross sectional views showing semiconductor devices according to embodiments of the present invention.
Figs. 10 to 39 are schematic cross sectional views showing the main portion during the steps of the method for manufacturing a pillar-shaped semiconductor layer according to embodiments of the present invention.
Figs. 40A to 41B are schematic views showing conventional semiconductor devices.

### DETAILED DESCRIPTION OF THE INVENTION

A semiconductor device having an SGT structure according to the present invention has one feature in that a semiconductor layer of a second conductive type or a cavity is provided in a pillar-shaped semiconductor layer of a first conductive type formed on a semiconductor substrate. Furthermore, the semiconductor device having an SGT structure according to the present invention has another feature in that a gate electrode is formed on a side face of the pillar-shaped semiconductor layer via a gate insulating film or a charge accumulation layer.

The semiconductor substrate that can be utilized for the present invention is not particularly limited, and any known substrates can be utilized. For example, a silicon substrate, a silicon germanium substrate and the like can be cited.

Next, the semiconductor material that constitutes the pillar-shaped semiconductor layer of the first conductive type formed on the semiconductor substrate is not particularly limited. For example, a semiconductor such as silicon can be cited. The first conductive type indicates either n- type or p-type. Phosphorous, arsenic or the like can be cited as an impurity that provides the n-type and boron or the like can be cited as an impurity that provides the p-type.

Next, the source and drain diffusion layers of the second conductive type are formed in the upper and lower portions of the pillar-shaped semiconductor layer. Here, the second conductive type indicates the n-type in the case when the first conductive type is the p-type and indicates the p-type in the case when the first conductive type is the n-type.

Next, the semiconductor layer of the second conductive type or the cavity is formed inside the pillar-shaped semiconductor layer. The semiconductor layer of the second conductive type is usually made of a semiconductor material of the same type as of the pillar-shaped semiconductor layer. The impurity concentration of the semiconductor layer of the second conductive type, the dimensions and forms of the semiconductor layer of the second conductive type and the cavity are not particularly limited as long as the substrate bias effect can be prevented.

The gate electrode is formed on a side face of the pillar-shaped semiconductor layer via a gate insulating film or a charge accumulation layer. Here, in the case where the semiconductor layer of the second conductive type is provided, either the gate insulating film or the charge accumulation layer may be provided while in the case of the cavity, the charge accumulation layer is provided.

The gate insulating film is not particularly limited, and any of the known insulating films can be utilized. For example, an insulating film such as a silicon oxide film, a silicon nitride film, a silicon oxide nitride film and a stacked body thereof, and a high-dielectric film such as an aluminum oxide film, a titanium oxide film, a tantalum oxide film and a hafnium oxide film can be cited.

The type of charge accumulation layer is not particularly limited as long as it has a function of accumulating charges. For example, a floating gate electrode made of polycrystal silicon, a silicon oxide film-silicon nitride film-silicon oxide film, a layer made of microscopic polycrystal silicon grains can be cited.

All of the materials that can be conventionally utilized for a gate electrode can be utilized as the material forming the gate electrode or the control gate electrode. Specifically, silicon, silicide, metals and the like can be cited.

Furthermore, a semiconductor device having an S-SGT structure according to the present invention has one feature in that a semiconductor layer of the second conductive type, an insulator or a cavity is provided in the pillar-shaped semiconductor layer of the first conductive type formed on the semiconductor substrate. Furthermore, the semiconductor device having an S-SGT structure has another feature in that the gate electrode is formed on a side face of the pillar-shaped semiconductor layer via a gate insulating film or a charge accumulation layer.

Plural SGTs are stacked in the S-SGT structure. The number of layers is not particularly limited as long as it is not smaller than two. Preferable numbers of the layer are 2ⁿ (n is a natural number). Specifically, 2, 4, 6 and 8 can be cited.

In addition, though the material that forms the insulator existing in the pillar-shaped semiconductor layer is not particularly limited, silicon oxide can be cited. The same elements as of the above-described SGT can be utilized for the components of the S-SGT, except for the insulator.

### EMBODIMENTS

In the following, embodiments of the present invention will be described with reference to the drawings.

### First Embodiment

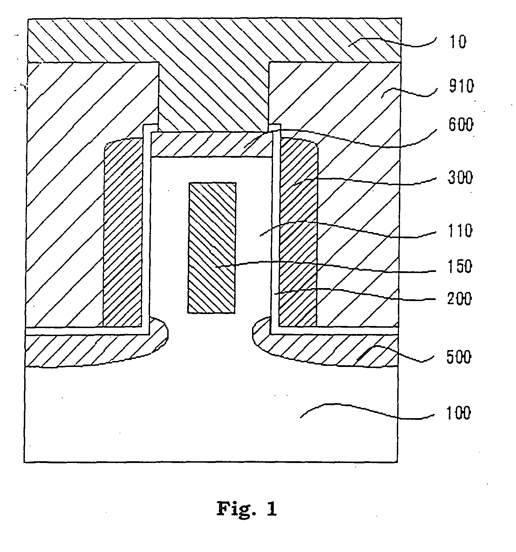

Fig. 1 is a schematic cross sectional view showing a MOS transistor having a three-dimensional structure according to one embodiment of the present invention. Here, an n-type MOS transistor is shown in this embodiment.

A pillar-shaped semiconductor layer 110 is formed on a p-type silicon substrate 100 according to this embodiment. In addition, at least one portion of a side face of the pillar-shaped semiconductor layer 110 is used as a surface of an active region and a gate oxide film 200 is formed on at least one portion of the surface of the active region by means of, for example, thermal oxidation. Furthermore, a gate electrode 300 made of, for example, polycrystal silicon is placed so as to cover at least a portion of the gate oxide film 200.

Then, source and drain diffusion layers (500, 600) formed of n-type diffusion layers are provided in the upper and lower surfaces of the pillar-shaped semiconductor layer 110, so that a MOS transistor (memory cell) having a three-dimensional structure is formed.

A semiconductor layer 150 of the conductivity, which is the n-type in this embodiment, opposite to that of the pillar-shaped semiconductor layer 110 is formed in at least a portion inside pillar-shaped semiconductor layer 110. The form and the dimensions of the semiconductor layer 150 are not particularly limited as long as the semiconductor layer 150 is formed inside the pillar-shaped semiconductor layer 110 and the pillar-shaped semiconductor layer 110 is completely depleted at the time of the channel inversion.

In the above-described structure, a PN junction is formed between the pillar-shaped semiconductor layer 110 and the semiconductor layer 150 formed inside the pillar-shaped semiconductor layer 110. Therefore, a depletion layer is formed inside the pillar-shaped semiconductor layer 110. As a result, the pillar-shaped semiconductor layer 110 can be easily and completely depleted at the time of the channel inversion even in the case where the pillar-shaped semiconductor layer 110 is wide and tall. Accordingly, a MOS transistor having an idealistic sub-threshold swing wherein the substrate bias effect has been reduced can be obtained. In Fig. 1, 910 indicates an interlayer insulating film.

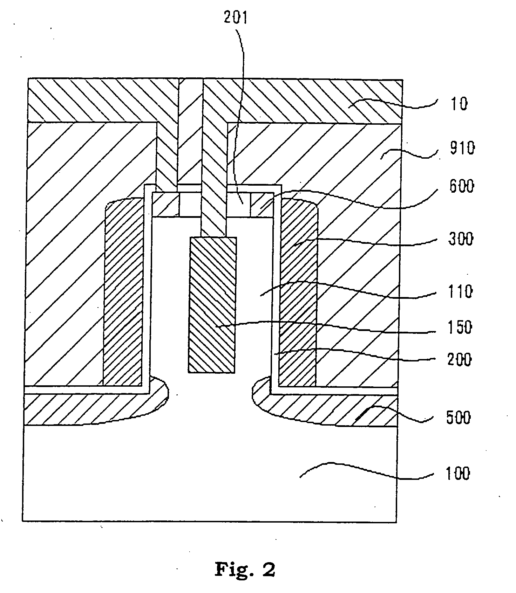

Furthermore, Fig. 2 shows the structure of the pillar-shaped semiconductor layer 110 in the case where an electrode 10 is formed on the semiconductor layer 150, of which the conductive type is opposite to that of the pillar-shaped semiconductor layer 110, and which has been formed inside the pillar-shaped semiconductor layer 110. In this structure, it becomes possible to control the potential of the semiconductor layer 150. In the case of this embodiment, for example, a reverse bias is applied to the PN junction formed between the pillar-shaped semiconductor layer 110 and the semiconductor layer 150 when a positive potential V1 is applied. As a result, the depletion layer spreads so that the pillar-shaped semiconductor layer 110 can be easily and completely depleted, even in the case where the pillar-shaped semiconductor layer 110 has a greater width. Accordingly, a MOS transistor having an idealistic sub-threshold swing where the substrate bias effect has been reduced can be obtained. In Fig. 2, 201 indicates an insulating film.

The semiconductor layer 150 can be easily formed by means of, for example, a diagonal ion implantation after the pillar-shaped semiconductor layer has been formed.

Here, though this embodiment shows a case of an n-type MOS transistor, this embodiment can of course be applied to a p-type MOS transistor by reversing the entire conductive types.

### Second Embodiment

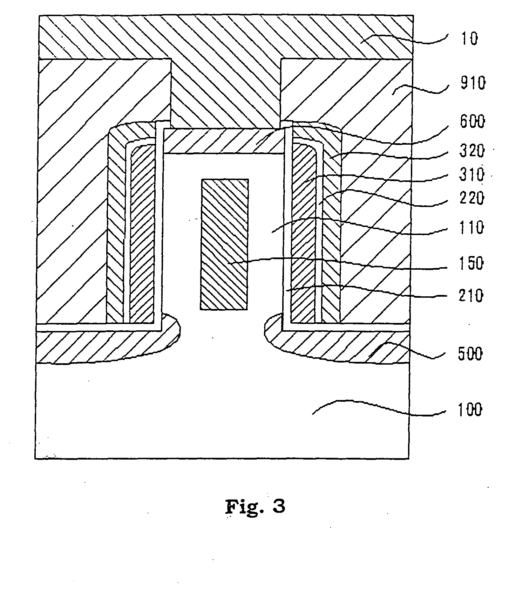

Next, another embodiment (second embodiment) of the present invention will be described with reference to Fig. 3.

Fig. 3 is a schematic cross sectional view showing an SGT flash memory having a three-dimensional structure. Here, this embodiment shows a SGT flash memory using a p-type substrate.

In this embodiment, a pillar-shaped semiconductor layer 110 is formed on a p-type silicon substrate 100. In addition, at least a portion of a side face of the pillar-shaped semiconductor layer 110 is used as a surface of the active region and a tunnel oxide film 210 is formed on at least a portion of the surface of the active region by means of, for example, thermal oxidation. Furthermore, a floating gate electrode 310 made of, for example, polycrystal silicon is placed so as to cover at least a portion of the tunnel oxide film 210. Then, an insulating film 220 made of, for example, a oxide film-silicon nitride film-silicon oxide film, that is, a so-called ONO film is placed so as to cover the floating gate electrode 310. In addition, a control gate electrode 320 is placed on the insulating film 220 in the structure.

Then, the source and drain diffusion layers (500, 600) formed of n-type diffusion layers are provided in the upper and lower surfaces of the pillar-shaped semiconductor layer 110, so that a memory having a three-dimensional structure is formed.

A semiconductor layer 150 of a conductive type, which is the n-type in this embodiment, opposite to that of the pillar-shaped semiconductor layer 110 is formed in at least a portion inside pillar-shaped semiconductor layer 110. Here, in the same manner as in the first embodiment, the semiconductor layer 150 is formed inside the pillar-shaped semiconductor layer 110 wherein the form and the dimensions of the semiconductor layer 150 are not particularly limited as long as the pillar-shaped semiconductor layer 110 is completely depleted at the time of the channel inversion.

In this embodiment, a PN junction is formed between the pillar-shaped semiconductor layer 110 and the semiconductor layer 150 formed inside the pillar-shaped semiconductor layer 110, as shown in the first embodiment. Therefore, a depletion layer is formed inside the pillar-shaped semiconductor layer 110. As a result, the pillar-shaped semiconductor layer 110 can be easily and completely depleted at the time of the channel inversion even in the case where the pillar-shaped semiconductor layer 110 is wide and tall. Accordingly, an SGT flash memory having an ideal sub-threshold swing where the substrate bias effect has been reduced can be obtained.

In addition, in this embodiment, an electrode may be formed on the semiconductor layer 150 that has been formed inside the pillar-shaped semiconductor layer 110, as shown in the first embodiment. In this configuration, the potential of semiconductor layer 150 can be controlled; therefore, the pillar-shaped semiconductor layer 110 can be easily and completely depleted even in the case where the pillar-shaped semiconductor layer 110 has a greater width. Accordingly, an SGT flash memory having an ideal sub-threshold swing where the substrate bias effect has been reduced can be obtained.

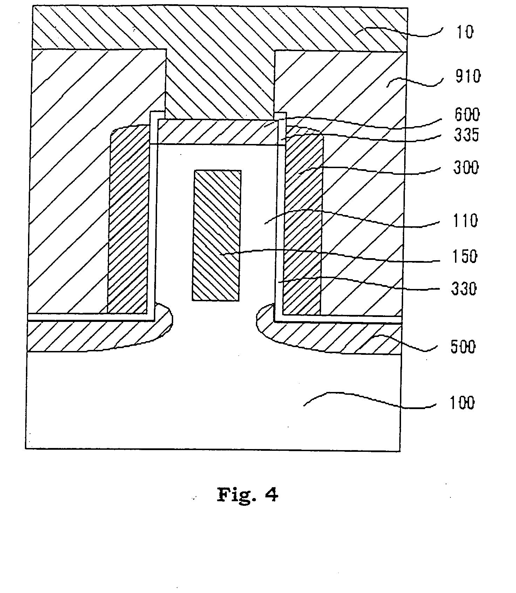

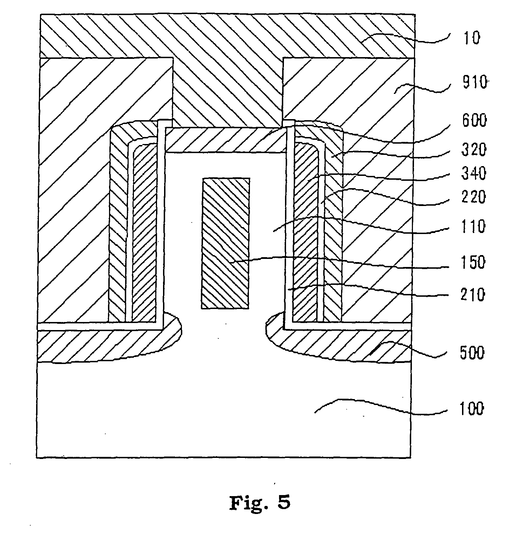

Here, the present invention is not limited to a flash memory where the floating gate electrode made of polycrystal silicon shown in this embodiment is used as the charge accumulation layer, but rather, the present invention can of course be applied to a so-called MONOS-type memory where a charge accumulation layer 330 made of a oxide film-nitride film-oxide film (ONO film) is used as shown in Fig. 4, or to a memory that uses a charge accumulation layer 340 made of microscopic crystal silicon as shown in Fig. 5.

Furthermore, though this embodiment shows a case of a p-type substrate, this embodiment can of course be applied to the case of an n-type substrate by reversing the entire conductive types.

### Third Embodiment

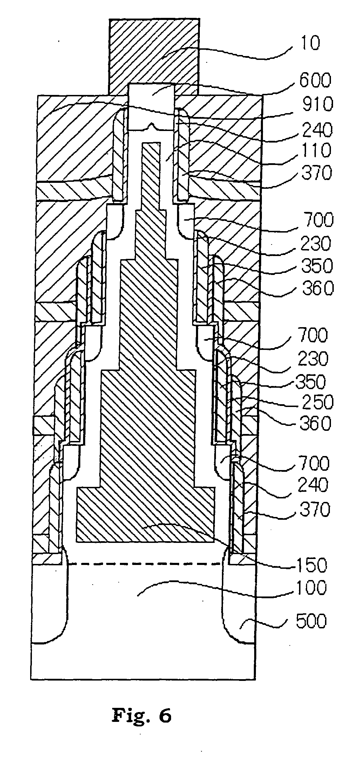

Next, still another embodiment (third embodiment) of the present invention will be described with reference to Fig. 6.

Fig. 6 is a schematic cross sectional view showing an S-SGT flash memory having a three-dimensional structure. Here, this embodiment shows a case where a p-type substrate is used.

In this embodiment, a pillar-shaped semiconductor layer 110 having at least two or more steps is formed on a p-type silicon substrate 100. A memory cell is formed in every pillar-shaped semiconductor layer 110 that forms each step.

A memory cell has a configuration as follows. First, at least two or more surfaces of a side face of the pillar-shaped semiconductor layer 110 are used as surfaces of the active regions and a tunnel oxide film 230 is formed on at least a portion of the above-described surfaces of the active regions by means of, for example, thermal oxidation. Furthermore, a floating gate electrode 350 made of, for example, polycrystal silicon is placed so as to cover at least a portion of the tunnel oxide film 230. Then, an insulating film 250 made of, for example, a silicon oxide film-silicon nitride film-silicon oxide film, that is, a so-called ONO film, is placed so as to cover the floating gate electrode 350. In addition, a control gate electrode 360 made of, for example, polycrystal silicon is placed on the insulating film 250.

At least two or more memory cells, each of which is the same as the above-described memory cell, are placed in series via diffusion layers 700 formed in portions of the pillar-shaped semiconductor layer 110. Furthermore, selector transistors are formed at both ends of the memory cells, which are connected in series, and are connected via diffusion layers 700.

The selector transistors are formed on the step of the uppermost portion and on the step of the lowermost portion of the pillar-shaped semiconductor layer 110 having steps. An individual selector transistor is formed of a gate oxide film 240 that covers at least a portion of a side face of the pillar-shaped semiconductor layer 110 and a selector gate electrode 370 that covers at least a portion of the gate oxide film 240.

Then, source and drain diffusion layers (500, 600) formed of n-type diffusion layers are provided in the upper and lower surfaces of the pillar-shaped semiconductor layer 110, so that an S-SGT flash memory having a three-dimensional structure is formed.

Here, the structure shown in Fig. 6 shows a case where the pillar-shaped semiconductor layer 110 has four steps.

A semiconductor layer 150 of the conductive type, which is the n-type in this embodiment, opposite to that of the pillar-shaped semiconductor layer 110 is formed in at least a portion of the inside of the pillar-shaped semiconductor layer 110. Here, this embodiment shows that the shape of the semiconductor layer 150 is the same step form as of the pillar-shaped semiconductor layer 110. However, the form and the dimensions of the semiconductor layer 150 are not particularly limited as long as it is formed inside the pillar-shaped semiconductor layer 110 and as long as the pillar-shaped semiconductor layer 110 is completely depleted at the time of the channel inversion of each of the entire memory cells and the selector transistors.

Also in this embodiment, a PN junction is formed between the pillar-shaped semiconductor layer 110 and the semiconductor layer 150 formed inside the pillar-shaped semiconductor layer 110, as shown in the first embodiment. Therefore, a depletion layer is formed inside the pillar-shaped semiconductor layer 110. As a result, the pillar-shaped semiconductor layer 110 can be easily and completely depleted at the time of the channel inversion, even in the case where the pillar-shaped semiconductor layer 110 is wide and tall. Accordingly, an S-SGT flash memory having an ideal sub-threshold swing where the substrate bias effect has been reduced can be obtained.

In addition, also in this embodiment, an electrode may be formed on the semiconductor layer 150 formed inside the pillar-shaped semiconductor layer 110 as shown in the first embodiment. In this configuration, the potential of the semiconductor layer 150 can be controlled; therefore, the pillar-shaped semiconductor layer 110 can be easily and completely depleted even in the case where the pillar-shaped semiconductor layer 110 has a greater width. Accordingly, an S-SGT flash memory having an ideal sub-threshold swing where the substrate bias effect has been reduced can be obtained.

In addition, though this embodiment shows a case where the pillar-shaped semiconductor layer 110 has four steps, the number of steps is not particularly limited as long as the pillar-shaped semiconductor layer has two or more steps. Furthermore, this embodiment shows a case where the lower the step, the greater the width of each of the pillar-shaped semiconductor layers which construct the stacked memory cells and selector transistors. However, each width may be the same and the relative relationships from among the respective widths are not particularly limited.

Here, as shown in the second embodiment, the present invention is also not limited to a flash memory where the floating gate electrode made of polycrystal silicon is used, but rather, the present invention can of course be applied to a so-called MONOS-type memory where a charge accumulation layer made of a silicon oxide film-silicon nitride film-silicon oxide film is used, or to a memory that uses a charge accumulation layer made of microscopic crystal silicon.

Furthermore, though this embodiment shows a case of a p-type substrate, this embodiment can of course be applied to the case of an n-type substrate by reversing the entire conductive types.

### Fourth Embodiment

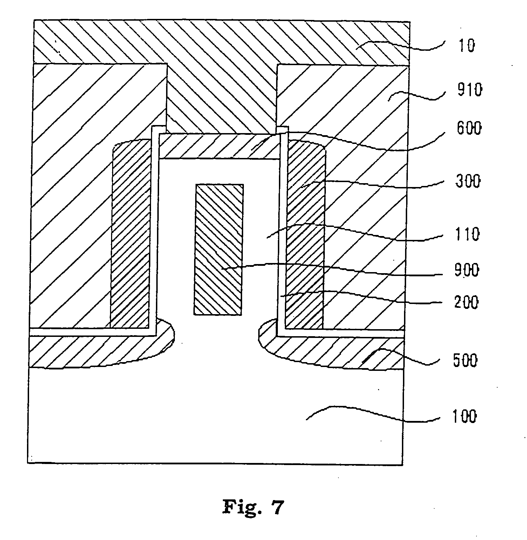

Next, yet another embodiment (fourth embodiment) of the present invention will be described with reference to Fig. 7.

Fig. 7 is a schematic cross sectional view showing a MOS transistor having a three-dimensional structure. Here, this embodiment shows an n-type MOS transistor.

This embodiment has a structure in that at least a portion of the inside of the pillar-shaped semiconductor layer 110 is hollowed out in the MOS transistor having a three-dimensional structure shown in the first embodiment.

Here, the following method for example, can be cited as a method for forming a cavity 900 inside the pillar-shaped semiconductor layer. That is, a pillar of a certain material (for example, oxide film) having a large etching ratio relative to Si is formed on a silicon substrate. Next, a Si epitaxial layer is formed on the surface of the pillar-shaped oxide film by means of the epitaxial method. After that, an opening is formed in a portion of the upper surface of the Si epitaxial layer, so that the pillar-shaped oxide film layer is etched and removed by means of wet etching using an HF solution, or the like and using the opening as a mask. Furthermore, the opening is closed with an epitaxial or a deposition of an oxide film. The cavity 900 can be obtained according to such a method.

As described above, at least a portion of the pillar-shaped semiconductor layer 110 is hallowed out; thereby, it becomes possible to obtain a MOS transistor which has an ideal sub-threshold swing or which does not have a substrate bias effect without miniaturizing the pillar-shaped semiconductor layer 110 to, for example, a sub-quarter micron level.

Here, the cavity 900 inside the pillar-shaped semiconductor layer 110 is formed inside the pillar-shaped semiconductor layer 110 and the shape and the dimensions of the cavity are not particularly limited as long as the pillar-shaped semiconductor layer 110 is completely depleted at the time of the channel inversion.

In addition, at least a portion of the pillar-shaped semiconductor layer can be hallowed out in a three-dimensional structure that has a memory cell structure as shown in the second and third embodiments in the same manner as described above; thereby, it of course becomes possible to obtain a MOS transistor which has an ideal sub-threshold swing or which does not have a substrate bias effect without miniaturizing the pillar-shaped semiconductor layer to, for example, a sub-quarter micron level.

Here, though this embodiment shows a case of an n-type MOS transistor, this embodiment can of course be applied to a p-type MOS transistor by reversing the entire conductive types.

### Fifth Embodiment

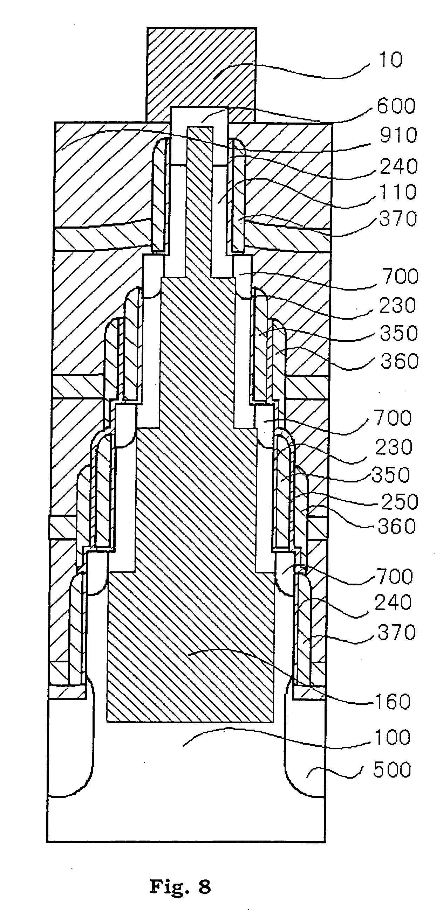

Next, yet another embodiment (fifth embodiment) of the present invention will be described with reference to Fig. 8.

Fig. 8 is a schematic cross sectional view showing an S-SGT flash memory having a three-dimensional structure according to the embodiment. Here, this embodiment shows an S-SGT flash memory using a p-type substrate.

In this embodiment, a pillar-shaped semiconductor layer 110 having at least two or more steps is formed on a p-type silicon substrate 100. A memory cell is formed in every pillar-shaped semiconductor layer 110 that forms each step.

The memory cell has the following configuration. First, at least two or more surfaces on the side face of this pillar-shaped semiconductor layer 110 are used as an active region surface and a tunnel oxide film 230 is formed on at least a portion of the surface of the active region surface by means of, for example, thermal oxidation. Furthermore, a floating gate electrode 350 made of, for example, polycrystal silicon is placed so as to cover at least a portion of the tunnel oxide film 230. Then, an insulating film 250 made of, for example, a silicon oxide film-silicon nitride film-silicon oxide film, a so-called ONO film is placed so as to cover the floating gate electrode. In addition, a control gate electrode 360 made of, for example, polycrystal silicon is placed on the insulating film 250.

At least two or more memory cells are placed in series via diffusion layers 700 which are formed in portions of the pillar-shaped semiconductor layer 110. Furthermore, selector transistors are provided at both ends of the memory cells connected in series via diffusion layers 700 in the structure.

The selector transistors are formed on the step of the uppermost portion and on the step of the lower most portion of the pillar-shaped semiconductor layer 110 having steps. Each of the selector transistors is formed of a gate oxide film 240 that covers at least a portion of the side face of the pillar-shaped semiconductor layer 110 and a selector gate electrode 370 that covers at least a portion of the gate oxide film 240.

Then, source and drain diffusion layers (500, 600) formed of n-type diffusion layers are placed in the upper and lower surfaces of the pillar-shaped semiconductor layer 110.

The structure shown in Fig. 8 exhibits a case where the pillar-shaped semiconductor layer 110 has four steps.

An insulator 160 is formed in at least a portion of the inside of the pillar-shaped semiconductor layer 110. Here, this embodiment shows that the insulator 160 has a similar step form to that of the pillar-shaped semiconductor layer 110. However, the shape and dimensions of the insulator 160 are not particularly limited as long as the insulator 160 is formed inside the pillar-shaped semiconductor layer 110 and the pillar-shaped semiconductor layer 110 is completely depleted at the time of the channel inversion of each of the entire memory cells and the selector transistors.

In addition, though a silicon oxide film, a silicon nitride film or the like is desirable for the insulator 160, the material is not particularly limited as long as it is an electrical insulator.

Also in this embodiment, a depletion layer is formed between the pillar-shaped semiconductor layer 110 and the insulator 160 formed inside the pillar-shaped semiconductor layer 110. Accordingly, the pillar-shaped semiconductor layer 110 can be easily and completely depleted at the time of the channel inversion even in the case where the pillar-shaped semiconductor layer 110 is wide and tall. Accordingly, an S-SGT flash memory which has an ideal sub-threshold swing and where the substrate bias effect has been reduced can be obtained.

In addition, though this embodiment shows a case where the pillar-shaped semiconductor layer 110 has four steps, the number of steps is not particularly limited as long as the semiconductor layer has two or more steps. Furthermore, this embodiment shows a case where the lower the step, the greater the width of each pillar-shaped semiconductor layer that forms a layered memory cell or a selector transistor. However, the respective widths may be the same and the relative relationships between the respective widths are not particularly limited.

Here, this embodiment can of course be applied to a so-called MONOS-type memory using a charge accumulation layer formed of a silicon oxide film-silicon nitride film-silicon oxide film and to a memory cell using a charge accumulation layer formed of microscopic crystal silicon in addition to a flash memory using a floating gate electrode formed of, for example, polycrystal silicon as shown in the second embodiment.

Furthermore, though the above-described embodiment exhibits a case of a p-type substrate, this embodiment can of course be applied to a case of an n-type substrate by reversing the entire conductive types.

### Sixth Embodiment

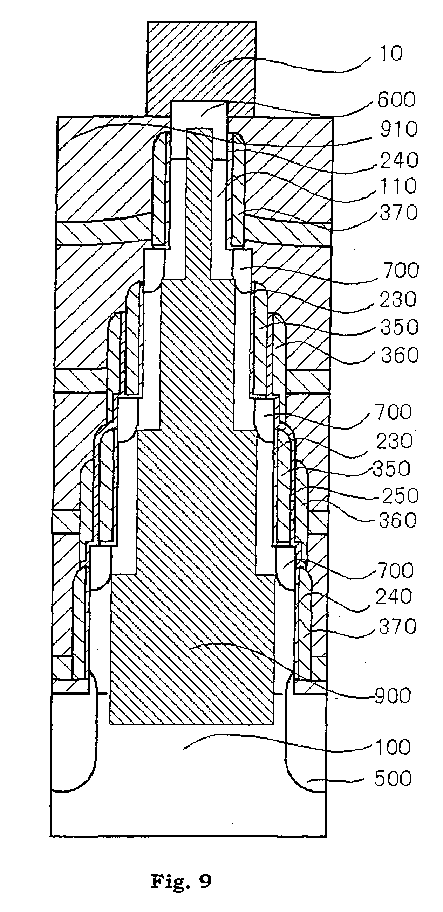

Next, yet another embodiment (sixth embodiment) of the present invention will be described with reference to Fig. 9.

Fig. 9 is a schematic cross sectional view showing an S-SGT flash memory having a three-dimensional structure according to the embodiment. Here, this embodiment shows an S-SGT flash memory using a p-type substrate.

In this embodiment, a pillar-shaped semiconductor layer 110 having at least two or more steps is formed on a p-type silicon substrate 100. A memory cell is formed in every pillar-shaped semiconductor layer 110 that forms each step.

The memory cell has the following structure. First, at least two or more surfaces on the side faces of the pillar-shaped semiconductor layer 110 are used as an active region surface and a tunnel oxide film 230 is formed on at least a portion of the active region surface by means of, for example, thermal oxidation. Furthermore, a floating gate electrode 350 made of, for example, polycrystal silicon is placed so as to cover at least a portion of the tunnel oxide film 230. Then, an insulating film 250 made of, for example, a silicon oxide film-silicon nitride film-silicon oxide film, a so-called ONO film is placed so as to cover the floating gate electrode. In addition, a control gate electrode 360 made of, for example, polycrystal silicon is placed on the insulating film 250.

At least two or more memory cells, each of which is the same as the above-described memory cell, are placed in series via diffusion layers 700 which are formed in portions of the pillar-shaped semiconductor layer 110. Furthermore, selector transistors are provided at both ends of the memory cells connected in series via diffusion layers 700 in the structure.

The selector transistors are formed on the step of the uppermost portion and on the step of the lower most portion of the pillar-shaped semiconductor layer 110 having steps. Each of the selector transistors is formed of a gate oxide film 240 that covers at least a portion of the side face of the pillar-shaped semiconductor layer 110 and a selector gate electrode 370 that covers at least a portion of the gate oxide film 240.

Then, source and drain diffusion layers (500, 600) formed of n-type diffusion layers are placed in the upper and lower surfaces of the pillar-shaped semiconductor layer 110.

The structure shown in Fig. 9 exhibits a case where the pillar-shaped semiconductor layer 110 has four steps.

A cavity 900 is formed in at least a portion inside of the pillar-shaped semiconductor layer 110. Here, this embodiment shows that the cavity 900 has a step form similar to that of the pillar-shaped semiconductor layer 110. However, the cavity 900 is formed inside the pillar-shaped semiconductor layer 110 and the shape and dimensions of the insulator are not particularly limited as long as the pillar-shaped semiconductor layer 110 is completely depleted at the time of the channel inversion of each of the entire memory cells and the selector transistors.

Also in this embodiment, a depletion layer is formed between the pillar-shaped semiconductor layer 110 and the cavity 900 formed inside the pillar-shaped semiconductor layer 110. Accordingly, the pillar-shaped semiconductor layer 110 can be easily and completely depleted at the time of the channel inversion even in the case where the pillar-shaped semiconductor layer 110 is wide and tall. Accordingly, an S-SGT flash memory which has an ideal sub-threshold swing and where the substrate bias effect has been reduced can be obtained.

In addition, though this embodiment shows a case where the pillar-shaped semiconductor layer 110 has four steps, the number of steps is not particularly limited as long as the semiconductor layer has two or more steps. Furthermore, this embodiment shows a case where the lower the step, the greater the width of each pillar-shaped semiconductor layer that forms a stacked memory cell or a selector transistor. However, the respective widths may be the same and the relative relationships between the respective widths are not particularly limited.

Here, this embodiment can of course be applied to a so-called MONOS-type memory using a charge accumulation layer formed of a silicon oxide film-silicon nitride film-silicon oxide film and to a memory cell using a charge accumulation layer formed of microscopic crystal silicon in addition to a flash memory using a floating gate electrode formed of, for example, polycrystal silicon as described in the second embodiment.

Furthermore, though this embodiment exhibits a case of a p-type substrate, this embodiment can of course be applied to a case of an n-type substrate by reversing the entire conductive types.

### Seventh Embodiment

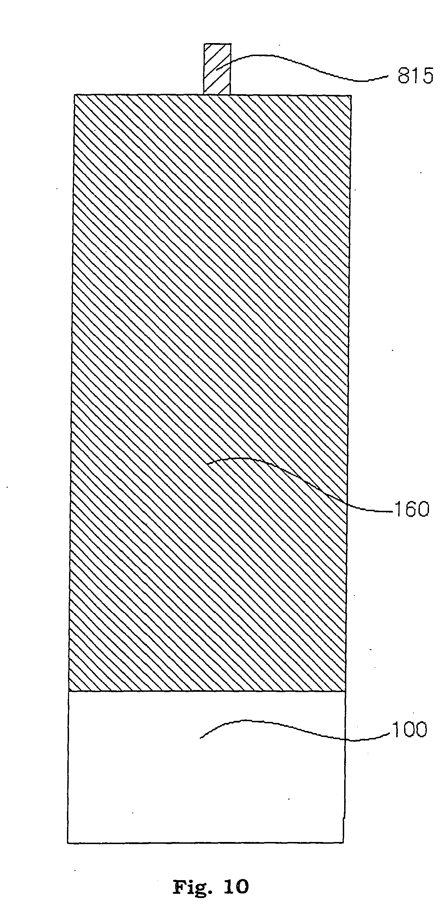

Next, yet another embodiment (seventh embodiment) of the present invention will be described with reference to Figs. 10 to 17.

A method for manufacturing a semiconductor layer on a pillar-shaped semiconductor substrate where the pillar-shaped semiconductor layer has at least two or more steps and an insulator is formed in at least a portion of the inside of the pillar-shaped semiconductor layer.

Here, Figs. 10 to 17 shown in the following are schematic cross sectional views showing the main portion during the steps of the method for manufacturing a pillar-shaped semiconductor layer according to this embodiment.

First, an insulator 160 made of, for example, a silicon oxide film is deposited on the surface of a semiconductor substrate, for example, a p-type silicon substrate 100 so as to have a thickness of 100 to 5000 nm. Next, a first insulation film, for example a silicon nitride film 815 that becomes a mask layer is deposited so as to have a thickness of 200 to 2000 nm. Furthermore, the silicon nitride film 815 is etched by means of, for example, reactive ion etching by using, as a mask, a resist R1 that has been formed on the silicon nitride film 815 and has been patterned by means of a well known photolithographic technology (Fig. 10).

Here, the mask layer is not limited to a silicon nitride film as long as it is made of a material which is not etched at the time of etching of the insulator 160, or of which the etching rate is lower than that of the insulator 160. Accordingly, the mask layer may be a conductive layer instead of an insulating film such as a silicon nitride film. In addition, the mask layer may be a layered film formed of two or more types of materials.

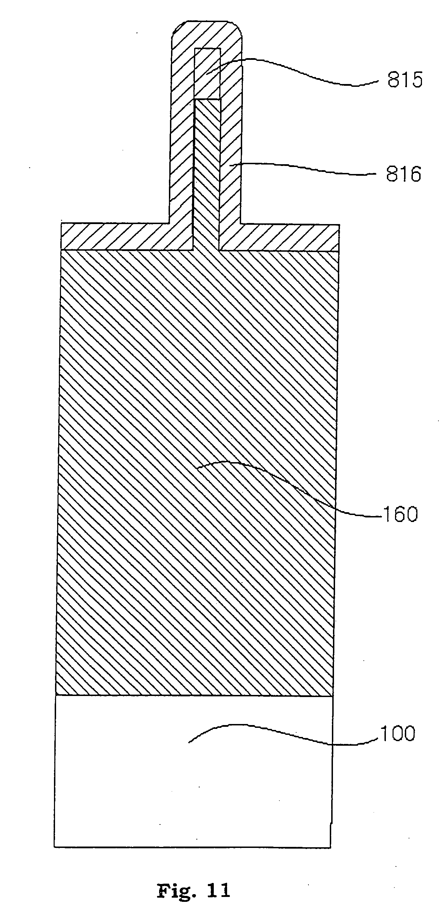

Then, the silicon nitride film 815 is used as a mask after the resist R1 has been removed, and the insulator 160 is etched by 50 to 5000 nm by means of, for example, reactive ion etching. Furthermore, as a second insulating film, for example, a silicon nitride film 816 is formed so as to have a thickness of 5 to 1000 nm (Fig. 11).

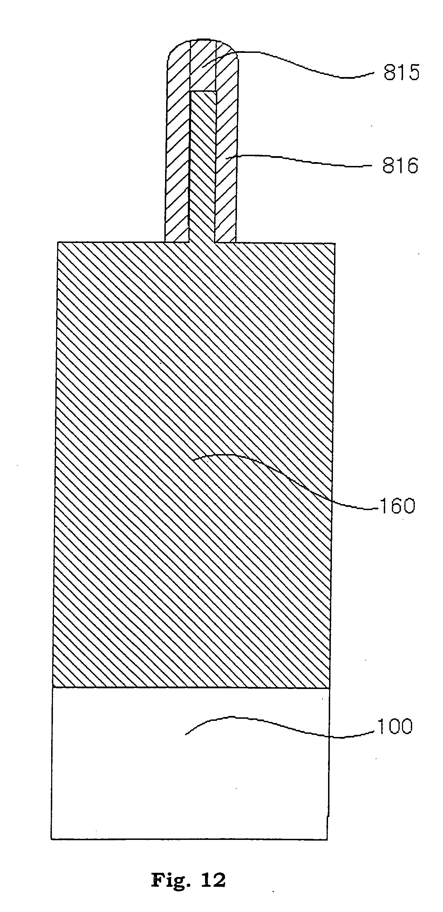

Then, the silicon nitride film 816 is processed by means of anisotropic etching to a sidewall spacer form which are placed on the side faces of the silicon nitride film 815 and on the side faces of the insulator 160 that has been processed to a pillar form (Fig. 12).

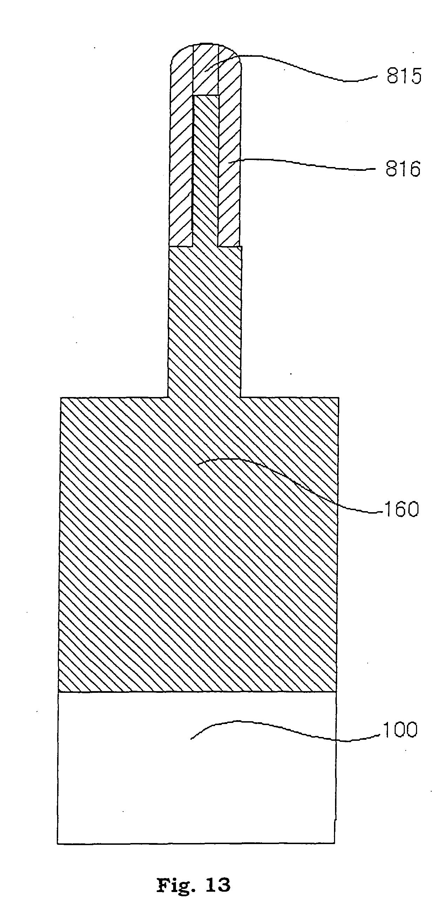

Next, the silicon nitride film 816 that has been processed to a sidewall spacer form is used as a mask and the insulator 160 is etched by 50 to 5000 nm by means of, for example, reactive ion etching. As a result of this etching, the insulator 160 is processed to a pillar form (Fig. 13).

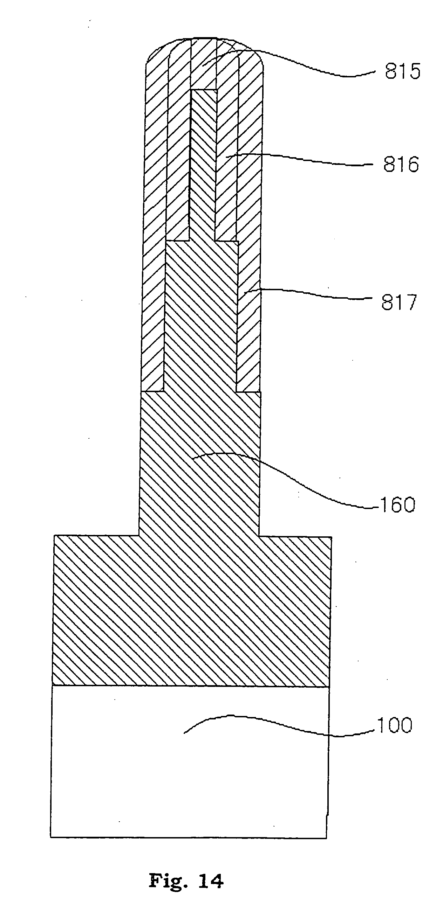

Subsequently, a silicon nitride film 817 is deposited as a third insulating film so as to have a thickness of 5 to 1000 nm. After that, the silicon nitride film 817 is processed by means of anisotropic etching to a sidewall spacer form which is formed on the side faces of the silicon nitride film 815, on the sides of the silicon nitride film 816 and on the side faces of the insulator 160 that has been processed to a pillar form. Then, the silicon nitride film 817 that has been processed to a sidewall spacer form is used as a mask so that the insulator 160 is etched by 50 to 5000 nm by means of, for example, reactive ion etching. As a result of this etching, the insulator 160 is processed to a pillar form (Fig. 14).

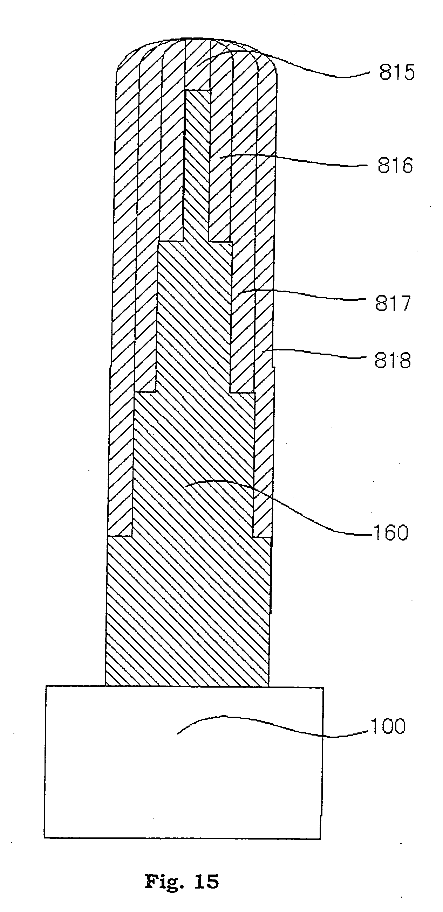

Subsequently, a silicon nitride film 818 is deposited as a fourth insulating film so as to have a thickness of 5 to 1000 nm. After that, the silicon nitride film 818 is processed by means of anisotropic etching to a sidewall spacer form which are placed on the side faces of the silicon nitride film 815, on the side faces of the silicon nitride film 816, on the side faces of silicon nitride film 817 and on the side faces of the insulator 160 that has been processed to a pillar form. Next, the silicon nitride film 818 that has been processed to a sidewall spacer form is used as a mask so that the insulator 160 is processed to a pillar form by means of, for example, reactive ion etching (Fig. 15).

As a result of the above-described process, the pillar-shaped insulator 160 having steps is formed on the semiconductor substrate.

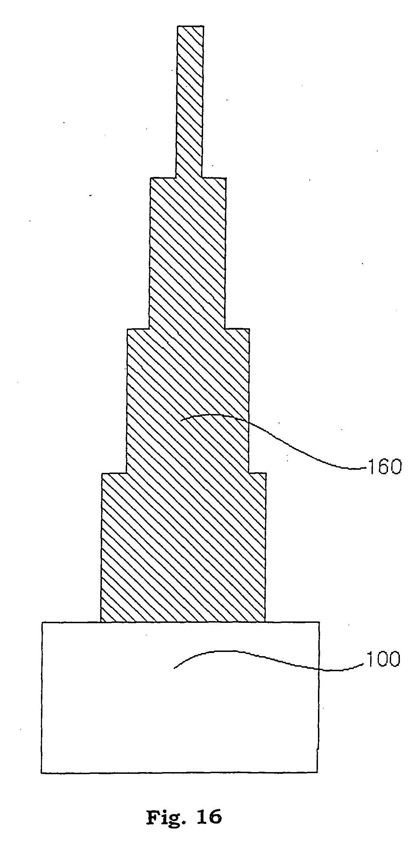

After that, the silicon nitride films 815 to 818 are selectively removed by means of, for example isotropic etching (Fig. 16).

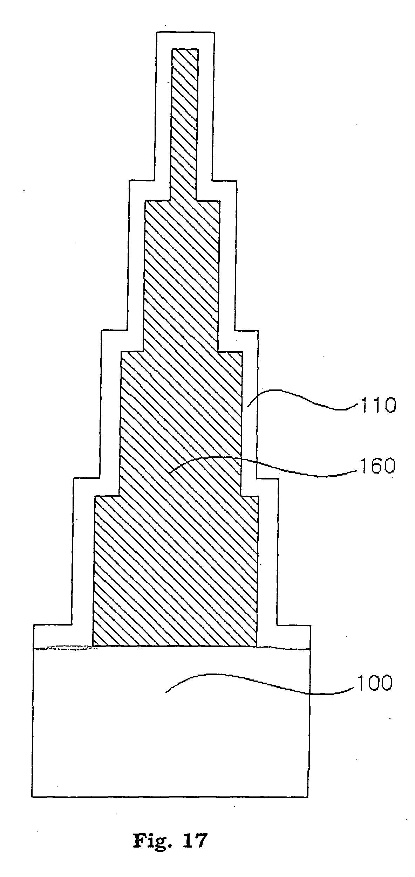

Subsequently, silicon is, for example, epitaxially grown on the p-type silicon substrate 100 and the insulator 160 so as to have a thickness of 5 to 5000 nm. As a result, a pillar-shaped semiconductor layer 110 which has at least two or more steps and where an insulator has been formed in at least a portion of the inside is formed on the semiconductor substrate (Fig. 17).

Here, though the insulator 160 is formed on the p-type semiconductor substrate in an example of this embodiment, the insulator 160 may be formed on an n-type substrate. In addition, it is preferable for the conductive type of the silicon that is epitaxially grown to be the same as that of the substrate.

In addition, in this embodiment, the silicon nitride films (815 to 818) which are the first to fourth insulating films are processed to a sidewall spacer form so that obtained sidewall spacers are used as masks at the time of reactive ion etching of the insulator 160; thereby, the insulator 160 is processed to a step form. In addition to this processing method, a method for processing the insulator 160 to a form having at least two or more steps by repeating: the process of exposing solely the edge portion of the insulator 160 by filling in the recesses with, for example, an insulating film or a conductive film; and the process of tapering the edge portion of the insulator 160 by carrying out, for example, isotropic etching on this exposed portion, may be used.

### Eighth Embodiment

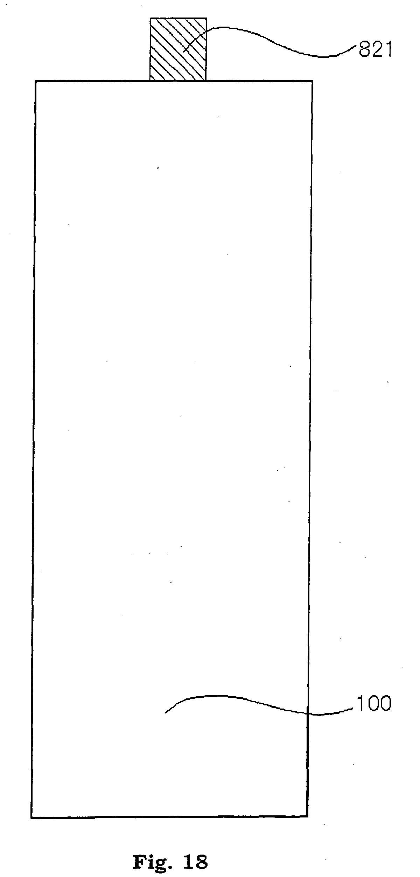

Next, yet another embodiment (eighth embodiment) of the present invention will be described with reference to Figs. 18 to 27.

This embodiment shows a method for manufacturing a pillar-shaped semiconductor layer wherein the pillar-shaped semiconductor layer having at least two or more steps is formed on a semiconductor substrate and a semiconductor layer of which the conductive type is opposite to that of the pillar-shaped semiconductor layer is formed in at least a portion of the inside of the pillar-shaped semiconductor layer.

Here, Figs. 18 to 27 shown in the following, are schematic cross sectional views showing the main portion of the steps of the method for manufacturing a pillar-shaped semiconductor layer according to this embodiment.

First, as a first insulating film, for example a silicon oxide film 821, which becomes a mask layer, is deposited on the surface of a semiconductor substrate, for example, a p-type silicon substrate 100 so as to have a thickness of 200 to 2000 nm. Next, a resist R2 that has been patterned according to a well known photolithographic technology is used as a mask so that the silicon oxide film 821 is etched by means of reactive ion etching (Fig. 18).

Here, the mask layer need not to be a silicon oxide film as long as it is made of a material that is not etched at the time of reactive etching of the p-type silicon substrate 100 or of which the etching rate is lower than that of silicon. Accordingly, the mask layer may be a conductive layer instead of an insulating layer such as the silicon oxide film. In addition, the mask layer may be a stacked film made of two or more types of materials.

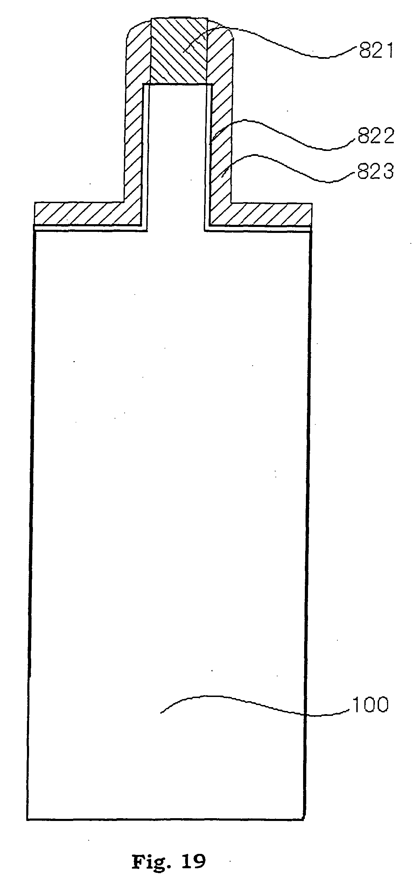

Then, the silicon oxide film 821 is used as a mask after the resist R2 has been removed and the p-type silicon substrate 100, which is the semiconductor substrate, is etched by 50 to 5000 nm by means of reactive ion etching. After that, thermal oxidation is carried out on the exposed portion of the p-type silicon substrate 100; thereby, a silicon oxide film 822, for example, which becomes a second insulating film, is formed so as to have a thickness of 5 to 100 nm. Here, the method for forming the silicon oxide film 822 is not limited to a thermal oxidation method but rather, may be a CVD method, for example. Furthermore, the material of the insulating film and the method for forming the insulating film are not particularly limited, as long as the obtained insulating film has desired properties. Next, a silicon nitride film 823, for example, is deposited as a third insulating film so as to have a thickness of 10 to 1000 nm (Fig. 19).

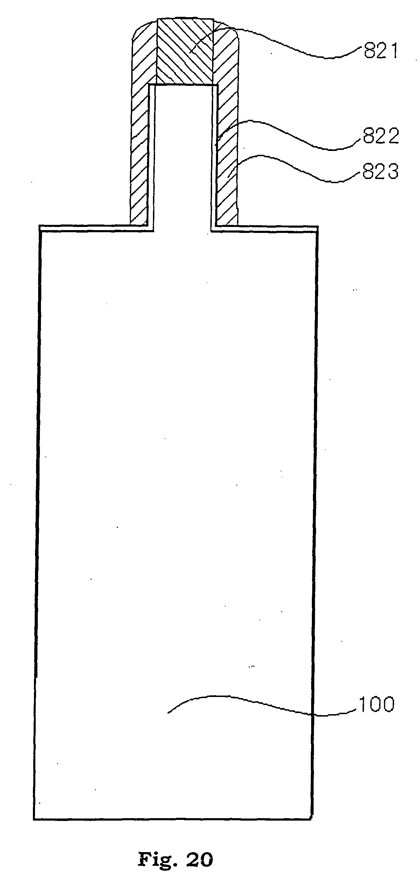

After that, the silicon nitride film 823 is processed by means of anisotropic etching to a sidewall spacer form which are placed on the sidewalls of the silicon oxide film 821 and on the sidewalls of the p-type silicon substrate 100 that has been processed to a pillar form via the silicon oxide film 822 (Fig. 20).

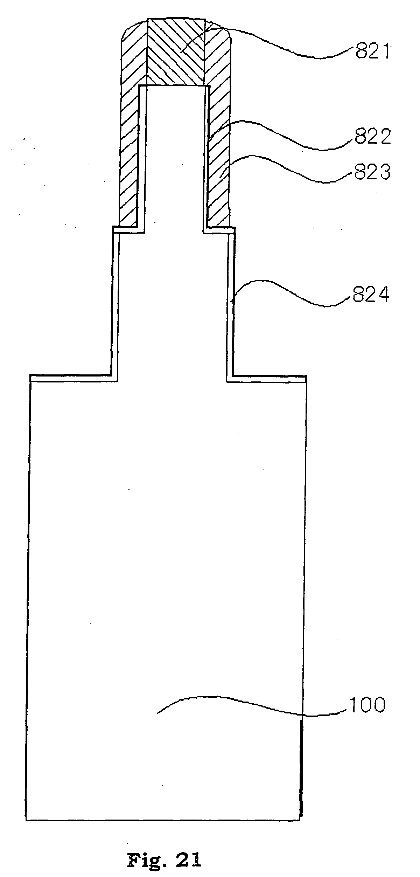

Subsequently, the silicon nitride film 823 that has been processed to a sidewall spacer form is used as a mask so that the silicon oxide film 822 is etched and removed by means of reactive ion etching. Subsequently, the exposed p-type silicon substrate 100 is etched by 50 to 5000 nm; thereby, the p-type silicon substrate 100 is processed to a pillar form having two steps. After that, thermal oxidation is carried out on the exposed portion of the p-type silicon substrate 100; thereby, a silicon oxide film 824, for example, which becomes a fourth insulating film, is formed to have a thickness of 5 to 100 nm (Fig. 21). Here, the method for forming the silicon oxide film 824 is not limited to thermal oxidation, but rather, may for example, be a CVD method. Furthermore, the material of the insulating film and the method for forming the insulating film are not particularly limited as long as the obtained insulating film has desired properties.

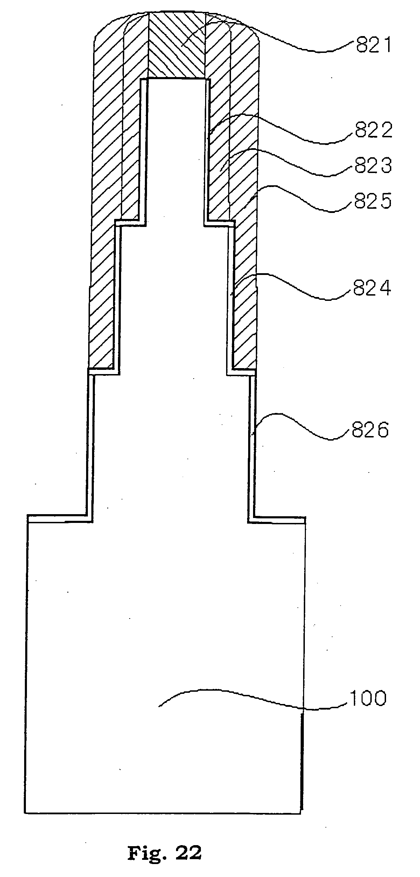

Next, a silicon nitride film 825, for example, is deposited as a fifth insulating film so as to have a thickness of 10 to 1000 nm. After that, the silicon nitride film 825 is processed by means of an isotropic etching to a sidewall spacer form which are placed on the sidewalls of the silicon oxide film 821, on the sidewalls of the silicon nitride film 823 and on the sidewalls of the p-type silicon substrate 100 that has been processed to a pillar form having two steps via the silicon oxide film 824. Subsequently, the silicon nitride film 825 that has been processed to a sidewall spacer form is used as a mask and the silicon oxide film 824 is etched and removed by means of reactive ion etching. Subsequently, the exposed p-type silicon substrate 100 is etched by 50 to 5000 nm; thereby, the p-type silicon substrate 100 is processed to a pillar form having three steps. After that, thermal oxidation is carried out on the exposed portions of the p-type silicon substrate 100; thereby, a silicon oxide film 826, for example, which becomes a sixth insulating film, is formed so as to have a thickness of 5 to 100 nm (Fig. 22). Here, the method for forming the silicon oxide film 826 is not limited to the thermal oxidation, but rather, may be a CVD method for example. Furthermore, the material of the insulating film and the method for manufacturing the insulating film are not particularly limited as long as a desired insulating film can be obtained.

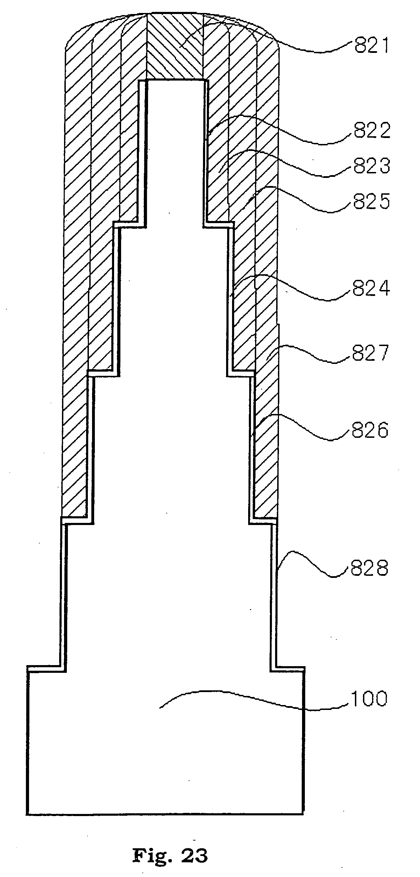

Next, a silicon nitride film 827, for example, is deposited as a seventh insulating film, so as to have a thickness of 10 to 1000 nm. After that, the silicon nitride film 827 is processed by means of an isotropic etching to a sidewall spacer form which are placed on the sidewalls of the silicon oxide film 821, on the sidewalls of the silicon nitride film 825 and on the sidewalls of the p-type silicon substrate 100 that has been processed to a pillar form having three steps via the silicon oxide film 826. Subsequently, the silicon nitride film 827 that has been processed to a sidewall spacer form is used as a mask and the silicon oxide film 826 is etched and removed by means of reactive ion etching. Subsequently, the exposed p-type silicon substrate 100 is etched by 50 to 5000 nm; thereby, the p-type silicon substrate 100 is processed to a pillar form having four steps. As a result of the above-described process, the pillar-shaped semiconductor layer 110 having steps is formed on the p-type silicon substrate 100 which is the semiconductor substrate. After that, thermal oxidation, for example, is carried out on the exposed portions of the p-type silicon substrate 100; thereby, a silicon oxide film 828, for example, is formed as an eighth insulating film so as to have a thickness of 5 to 100 nm (Fig. 23). Here, the silicon oxide film 828 may be formed by means of deposition instead of thermal oxidation. In addition, the insulating film is not limited to the silicon oxide film, but rather, may be a silicon nitride film. Furthermore, the insulating film may not necessarily be formed.

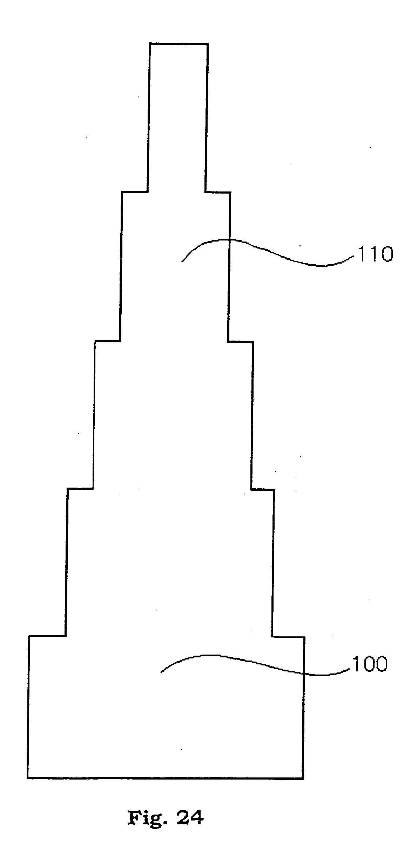

Subsequently, the silicon nitride films (823, 825 and 827) and the silicon oxide films (821, 822, 824, 826 and 828) are selectively removed by means of, for example, isotropic etching (Fig. 24).

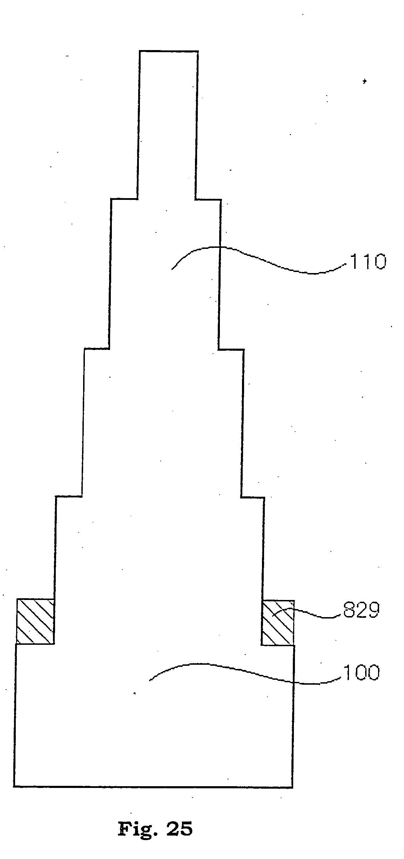

Next, a silicon oxide film 829, which becomes a ninth insulating film, is deposited by means of, for example a CVD method. Here, the ninth insulating film may not be a silicon oxide film as long as it is made of a material that is not etched at the time of etching of silicon or of which the etching rate is lower than that of silicon and the material of the ninth insulating film and the method for forming the ninth insulating film are not particularly limited. Accordingly, the insulating film may be, for example, a silicon nitride film or may be a conductive film. In addition, the insulating film may be a stacked film formed of two or more types of materials. Then, the pillar-shaped semiconductor layer 110 is exposed by means of, for example, a resist etch back method (Fig. 25). Here, the method for exposing the pillar-shaped semiconductor layer 110 is not particularly limited as long as the desired structure can be implemented. For example, isotropic etching may be carried out from the upper surface portion of the semiconductor substrate in order to implement the desired structure.

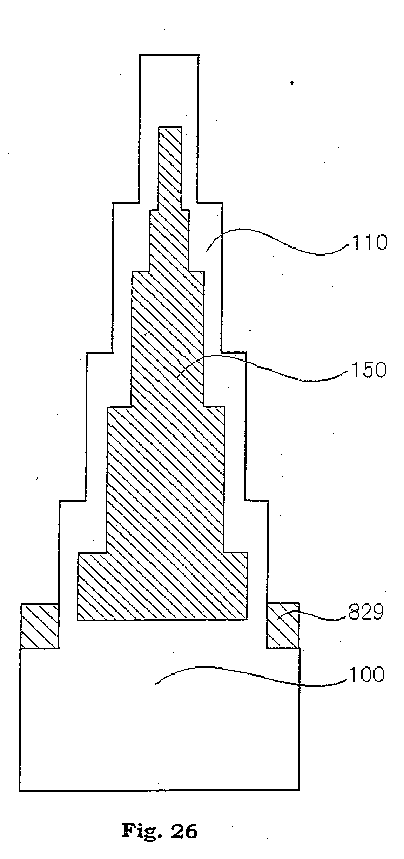

After that, a semiconductor layer 150 of which the conductive type is opposite to that of the pillar-shaped semiconductor layer 110 is formed inside the pillar-shaped semiconductor layer 110; therefore, ion implantation is carried out on the pillar-shaped semiconductor layer 110 by utilizing, for example, an oblique ion implantation. The following conditions of the ion implantation can be cited: the ions are implanted, for example, in a direction inclined from a line perpendicular to the main surface of the substrate by 5°to 80°; the injection energy is 5 keV to 1 MeV; the type of implanted ions is phosphorous; and the level of dosage is approximately 1 × 10¹⁰ to 1 × 10¹⁶/cm². The semiconductor layer 150 of which the conductive type, n-type in this embodiment, is opposite to that of the pillar-shaped semiconductor layer 110 is formed inside the pillar-shaped semiconductor layer 110 by carrying out the above-described process (Fig. 26). Here, the type of the implanted ions for the formation of the semiconductor layer 150 is not particularly limited as long as the ion implantation provides the conductive type opposite to that of the pillar-shaped semiconductor layer. In the case where the conductive type of the pillar-shaped semiconductor layer 110 is of the p-type, for example, phosphorous, arsenic or the like is preferable while in the case where the conductive type of the pillar-shaped semiconductor layer 110 is of the n-type, for example, boron or the like is preferable.

In addition, after ion implantation has been carried out in order to form the semiconductor layer 150, heat treatment may be carried out at, for example 500°C to 1200°C, so that the impurity concentration distribution may be converted to a desired distribution in the semiconductor layer 150.

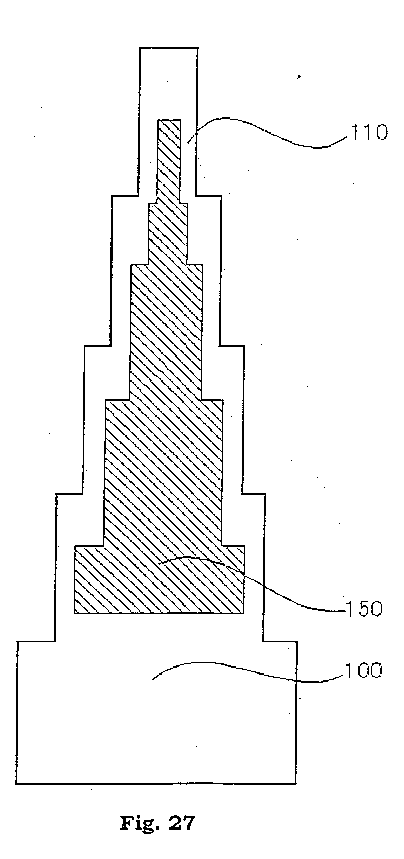

Next, anisotropic etching is, for example, carried out in order to remove the silicon oxide film 829. As a result of the above-described process, the pillar-shaped semiconductor layer 110 having the semiconductor layer 150 of which the conductive type is opposite to that of the above-described pillar-shaped semiconductor layer is formed inside the pillar-shaped semiconductor layer (Fig. 27).

Here, in this embodiment, the silicon nitride films (823, 825 and 827) are processed to a sidewall spacer form and obtained sidewall spacers are used as the masks at the time when reactive ion etching is carried out on the pillar-shaped semiconductor layer 110; thereby, the pillar-shaped semiconductor layer 110 is processed to a step form. However, only the edge portion of the pillar-shaped semiconductor layer 110 may be exposed by filling in the recesses with, for example, an insulating film or a conductive film and isotropic etching, for example, may be carried out on this exposed portion so that the edge portion of the pillar-shaped semiconductor layer 110 is tapered. Thus, the above-described process may be repeated; thereby, the pillar-shaped semiconductor layer 110 may be processed to a form having at least two or more steps.

In addition, in this embodiment, the semiconductor layer 150 of which the conductive type is opposite to that of the pillar-shaped semiconductor layer 110 is formed inside the pillar-shaped semiconductor layer 110 by carrying out ion implantation. However, n-type silicon is epitaxially grown on the p-type silicon substrate 100 so as to have a thickness of, for example 50 to 5000 nm and, after that, the above-described n-type silicon is processed to a pillar-shaped semiconductor layer having at least two or more steps. Then, p-type silicon is epitaxially grown so as to have a thickness of, for example, 5 to 1000 nm; thereby, the semiconductor layer of which the conductive type is opposite to that of the pillar-shaped semiconductor layer may be formed inside the pillar-shaped semiconductor layer.

Furthermore, though this embodiment shows a case of p-type substrate, this embodiment can of course be applied to a case of an n-type substrate by reversing the entire conductive types.

### Ninth Embodiment

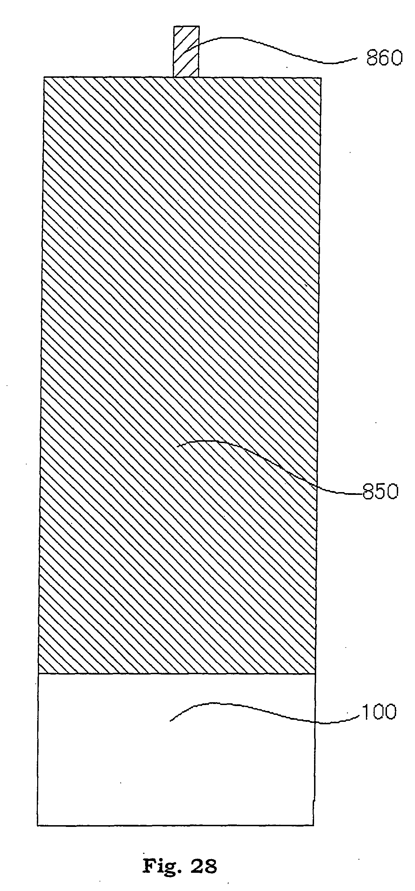

Next, yet another embodiment (ninth embodiment) of the present invention will be described with reference to Figs. 28 to 39.

This embodiment shows a method for manufacturing a pillar-shaped semiconductor layer where the pillar-shaped semiconductor layer having at least two or more steps is formed on a semiconductor substrate and a cavity is formed in at least a portion of the inside of the above-described pillar-shaped semiconductor layer.

Here, Figs. 28 to 39 shown in the following are schematic cross sectional views showing the main portion of the steps of a method for manufacturing a pillar-shaped semiconductor layer according to this embodiment.

First, an insulator 850 made of, for example, a silicon oxide film is deposited on the surface of a semiconductor substrate, for example, a p-type silicon substrate 100 so as to have a thickness of 100 to 5000 nm. Next, a silicon nitride film 860, for example, which becomes a mask layer, is deposited as a first insulating layer, so as to have a thickness of 200 to 2000 nm. Next, a resist R3 that has been patterned according to a well known photolithographic technology is used as a mask and the silicon nitride film 860 is etched by means of, for example, reactive ion etching (Fig. 28).

Here, the material of the mask layer is not particularly limited as long as the mask layer is not etched at the time when silicon is etched, or the etching rate of the mask layer is lower than that of silicon, and in addition, silicon is not etched at the time when the insulator 850 is etched, or the etching rate of the mask layer is lower than that of the insulator 850. Accordingly, the mask layer may be a conductive layer instead of the insulating film such as the silicon nitride film. In addition, the mask layer may be a stacked film made of two or more types of materials.

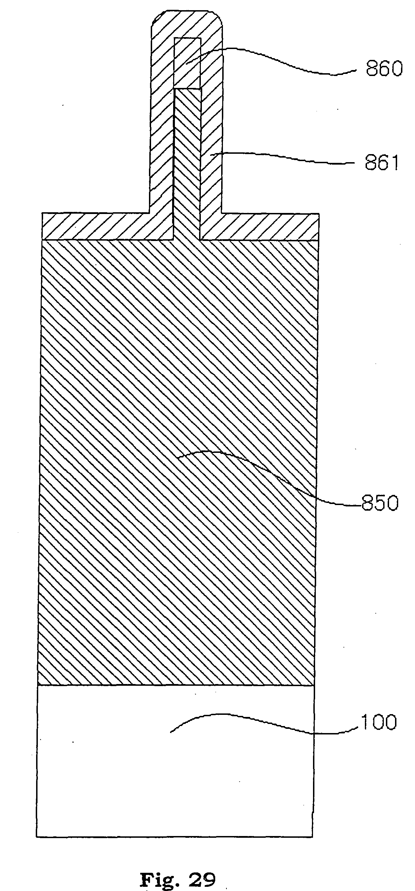

Then, the silicon nitride film 860 is used as a mask after the resistor R3 has been removed, and the insulator 850 is etched by 50 to 5000 nm by means of, for example, reactive ion etching. After that, a silicon nitride film 861, for example, is formed as a second insulating film so as to have a thickness of 5 to 1000 nm (Fig. 29).

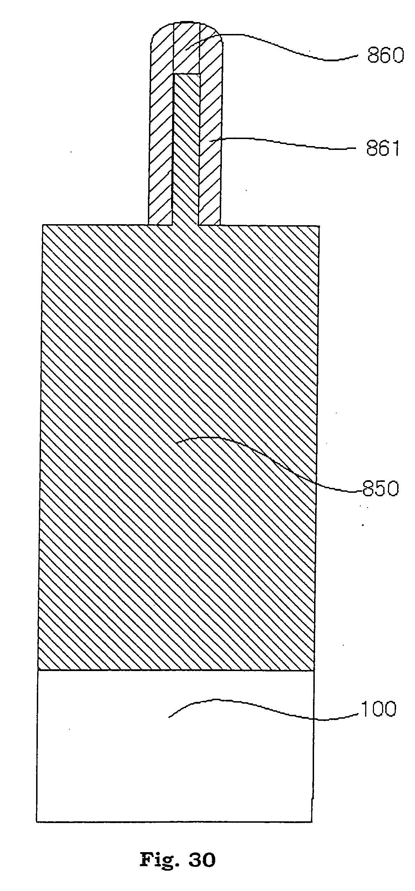

Then, the silicon nitride film 861 is processed by means of anisotropic etching to a sidewall spacer form which are placed on the side faces of the silicon nitride film 860 and on the side faces of the insulator 850 that has been processed to a pillar form (Fig. 30).

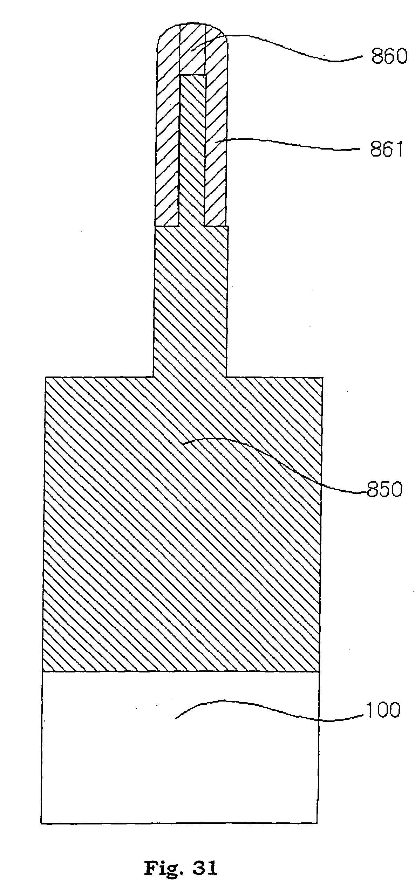

Next, the silicon nitride film 861 that has been processed to a sidewall spacer form is used as a mask and the insulator 850 is etched by 50 to 5000 nm by means of, for example, reactive ion etching; thereby, the insulator 850 is processed to a pillar form (Fig. 31).

Subsequently, the silicon nitride film 862 is deposited as a third insulating film so as to have a thickness of 5 to 1000 nm. After that, the silicon nitride film 862 is processed by means of anisotropic etching to a sidewall spacer form which is placed on the side faces of the silicon nitride film 860, on the side faces of silicon nitride film 861 and on the side faces of the insulator 850 that has been processed to a pillar form.

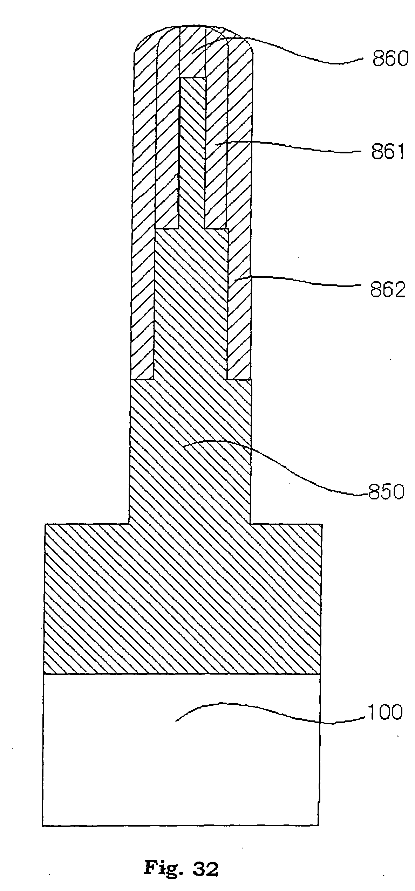

Then, the silicon nitride film 862 that has been processed to a sidewall spacer form is used as a mask and the insulator 850 is etched by 50 to 5000 nm by means of, for example, reactive ion etching; thereby, the insulator 850 is processed to a pillar form (Fig. 32).

Subsequently, a silicon nitride film 863 is deposited as a fourth insulating film so as to have a thickness of 5 to 1000 nm. After that, the silicon nitride film 863 that is the fourth insulating film is processed by means of anisotropic etching to a sidewall spacer form which are placed on the side faces of the silicon nitride film 860, on the side faces of the silicon nitride film 861, on the side faces of the silicon nitride film 862 and on the side faces of the insulating film 850 that has been processed to a pillar form.

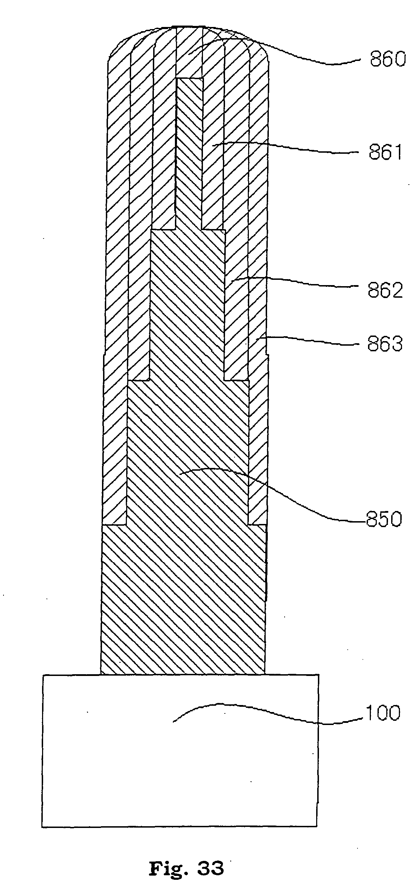

Next, the silicon nitride film 863 that is the fourth insulating film that has been processed to a sidewall spacer form is used as a mask and the insulator 850 is processed to a pillar form by means of, for example, reactive ion etching (Fig. 33).

As a result of the above-described process, the pillar-shaped insulator 850 having steps is formed on the semiconductor substrate.

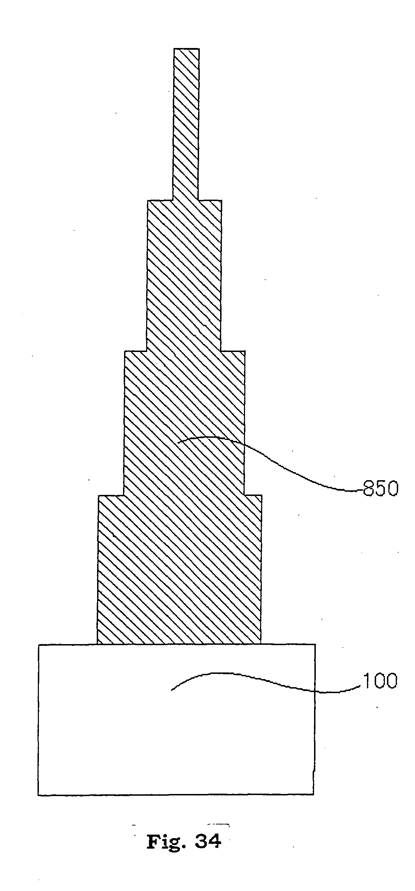

After that, the silicon nitride films 860 to 863 are selectively removed by means of, for example isotropic etching (Fig. 34).

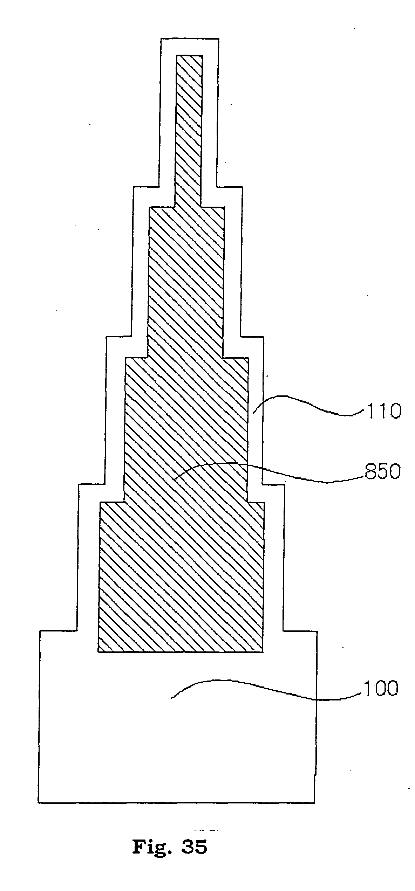

Subsequently, silicon is epitaxially grown on the silicon substrate 100 and on the insulator 850 so as to have a thickness of 5 to 5000 nm. As a result, the pillar-shaped semiconductor layer 110 which has at least two or more steps and where an insulator is formed in at least a portion of the inside is formed on the semiconductor substrate (Fig. 35).

Here, in this embodiment, the silicon nitride films (860 to 863) that are the first to fourth insulating films are processed to a sidewall spacer form and obtained sidewall spacers are used as a mask at the time of reactive ion etching of the insulator 850; thereby, the insulator 850 is processed to a step form. However, only the edge portion of the insulator 850 may be exposed by filling in the recesses with, for example, an insulating film or a conductive film and isotropic etching, for example, may be carried out on this exposed portion so that the edge portion of the insulator 850 is tapered. Thus, the above-described process may be repeated, so that the insulator 850 is processed to a form having at least two or more steps.

Next, a silicon oxide film 870 which becomes a fifth insulating film is deposited by means of, for example, a CVD method. Here, the material of the fifth insulating film and the method for forming the fifth insulating film are not particularly limited as long as the fifth insulating film is not etched at the time when silicon is etched or the etching rate of the material is lower than that of silicon. Accordingly, the fifth insulating film may be a silicon nitride film instead of the silicon nitride film or may be a conductive film. In addition, the fifth insulating film may be a stacked film formed of two or more types of materials.

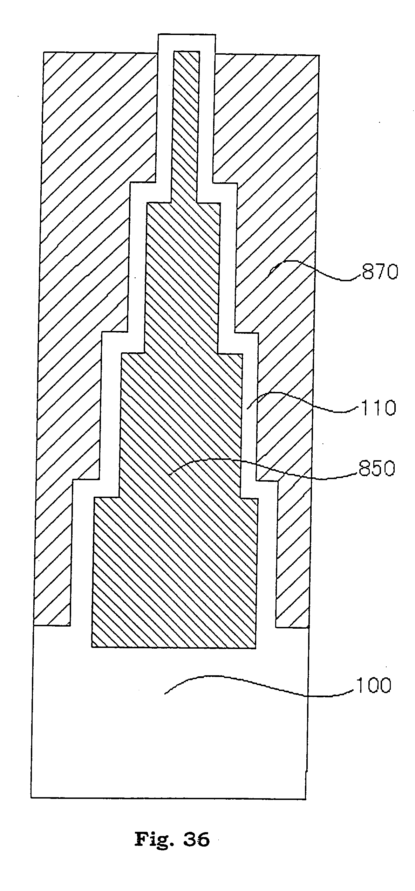

Then, the edge portion of the pillar-shaped semiconductor layer 110 is exposed by means of, for example, a resist etch back method (Fig. 36).

Here, the method for exposing the edge portion of the pillar-shaped semiconductor layer 110 is not particularly limited as long as a desired structure can be implemented. Isotropic etching may be carried out from the upper surface portion of the semiconductor substrate, for example; thereby, the desired structure may be implemented.

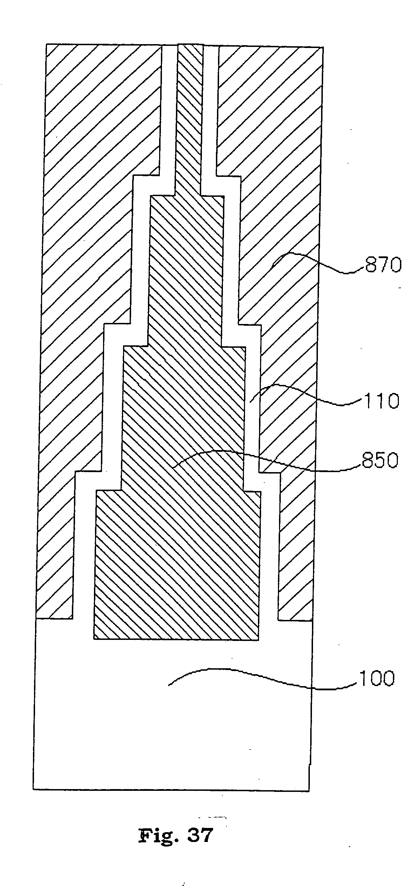

Then, silicon of the edge portion of the pillar-shaped semiconductor layer 110 that has been exposed by means of resist etch back is removed (Fig. 37).

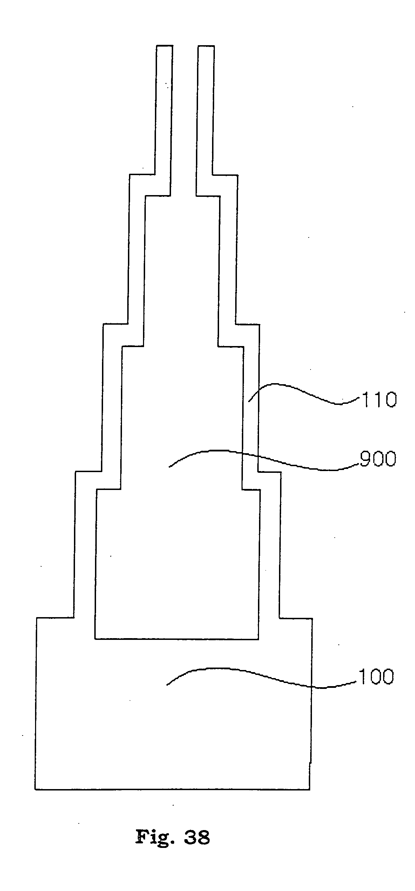

Next, a cavity 900 is formed by etching the insulator 850 by means of, for example, isotropic etching (Fig. 38). Here, it is preferable to etch the silicon oxide film 870 at the same time when the insulator 850 is etched. However, the silicon oxide film 870 may be etched by means of, for example, isotropic etching after the insulator 850 has been etched.

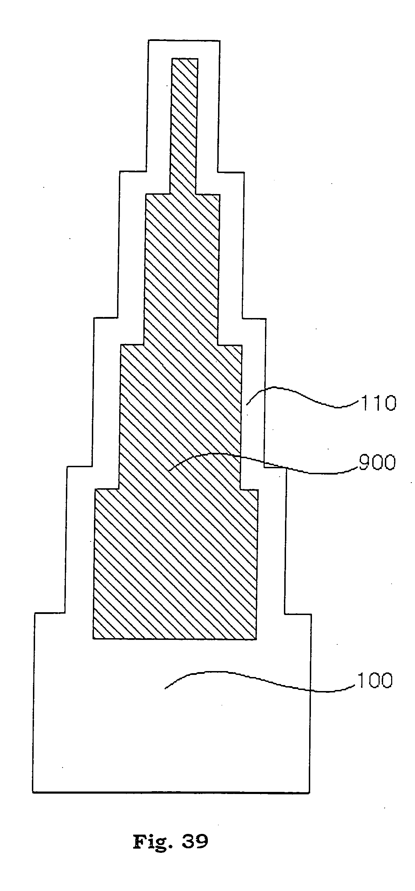

Next, silicon is, for example, epitaxially grown so as to have a thickness of approximately 5 to 1000 nm; thereby, the edge portion of the pillar-shaped semiconductor layer 110 with the cavity 900 inside is closed (Fig. 39). Here, the method for closing the edge portion of the pillar-shaped semiconductor layer 110 is not particularly limited as long as a predetermined structure can be implemented. The closure of the edge portion may be carried out by forming a silicon oxide film by means of, for example, thermal oxidation or by depositing, for example, a silicon oxide film.

As a result of the above-described process, the pillar-shaped semiconductor layer 110 which has at least two or more steps and where a cavity is formed in at least a portion of the inside can be formed on the semiconductor substrate.

Here, in this embodiment, a method for etching the edge portion of the pillar-shaped semiconductor layer 110 is utilized after the edge portion of the pillar-shaped semiconductor layer 110 has been exposed by filling in the recesses with an insulating film. However, the method is not particularly limited as long as a desired structure can be implemented. An opening is formed in the resist only on the edge portion of the pillar-shaped semiconductor layer 110 by means of, for example, a well known photolithographic technology so that etching is carried out; thereby, only the edge portion of the pillar-shaped semiconductor layer 110 may be etched.

In addition, though this embodiment shows a case of a p-type substrate, this embodiment can of course be applied to a case of an n-type substrate by reversing the entire conductive types.

As described above, according to the semiconductor device of the present invention, the entirety of the pillar-shaped semiconductor layer can be completely depleted regardless of the width, the height and the number of layers of the pillar-shaped semiconductor layer. As a result, a semiconductor device, such as a MOS transistor or a flash memory, which has an ideal sub-threshold swing and which does not have a substrate bias effect can be obtained. Accordingly, the semiconductor device of the present invention allows for the reduction in the consumed power and allows for high speed operation.

## Claims

1. A semiconductor device comprising a memory cell which includes:
a pillar-shaped semiconductor layer of a first conductive type formed on a semiconductor substrate;
source and drain diffusion layers of a second conductive type formed in upper and lower portions of the pillar-shaped semiconductor layer;
a semiconductor layer of the second conductive type or a cavity formed inside the pillar-shaped semiconductor layer; and
a gate electrode formed on a side face of the pillar-shaped semiconductor layer via a gate insulating film, or a control gate electrode formed on the side face of the pillar-shaped semiconductor layer via a charge accumulation layer.

2. A semiconductor device of claim 1, wherein the two or more memory cells are stacked on the semiconductor substrate, the pillar-shaped semiconductor layers forming the respective memory cells have a step-like structure in that the pillar-shaped semiconductor layers are stacked so that the cross-sectional areas in the horizontal direction relative to the surface of the semiconductor substrate become smaller, step by step.

3. A semiconductor device of claim 2, wherein the charge accumulation layer or the control gate electrode is placed over a step portion of the stacked body of the pillar-shaped semiconductor layers having a step-like structure and over a side face of the pillar-shaped semiconductor layer directly above the step portion.

4. A semiconductor device of claim 1, further comprising an electrode connected with the semiconductor layer of the second conductive type formed inside the pillar-shaped semiconductor layer, and controlled the potential of the semiconductor layer of the second conductive type.

5. A semiconductor device of claim 1, wherein the semiconductor layer of the second conductive type or the cavity has the form and the dimension being completely depleted the pillar-shaped semiconductor layer at the time of a channel inversion.

6. A semiconductor device comprising two or more stacked memory cells each of which includes:
a pillar-shaped semiconductor layer formed on a semiconductor substrate;
source and drain diffusion layers of a second conductive type formed in upper and lower portions of the pillar-shaped semiconductor layer;
an insulator formed inside the pillar-shaped semiconductor layer; and
a control gate electrode formed on a side face of the pillar-shaped semiconductor layer via a charge accumulation layer, wherein the pillar-shaped semiconductor layers forming the respective memory cells have a step-like structure in that the pillar-shaped semiconductor layers are stacked so that the cross-sectional areas in the horizontal direction relative to the surface of the semiconductor substrate become smaller, step by step, and
the charge accumulation layer or the control gate electrode is placed over a step portion of the stacked body of the pillar-shaped semiconductor layers having a step-like structure and over a side face of the pillar-shaped semiconductor layer directly above the step portion.

7. A semiconductor device of any preceding claim, wherein the charge accumulation layer is a floating gate electrode made of polycrystal silicon.

8. A semiconductor device of any preceding claim, wherein the charge accumulation layer is a silicon oxide film-silicon nitride film-silicon oxide film.

9. A semiconductor device of any preceding claim, wherein the charge accumulation layer is a layer made of microscopic polycrystal silicon grains.

10. A semiconductor device of claims 6 or 9, wherein the insulator has the form and the dimension being completely depleted the pillar-shaped semiconductor layer at the time of a channel inversion.
